(19) **Europäisches Patentamt / European Patent Office / Office européen des brevets**

(11) **EP 4 490 335 B1**

(12) **EUROPEAN PATENT SPECIFICATION**

(45) Date of publication and mention
of the grant of the patent:
**06.05.2026 Bulletin 2026/19**

(21) Application number: **23709435.4**

(22) Date of filing: **09.03.2023**

(51) International Patent Classification (IPC):
$C23C\ 14/00^{(2006.01)}$    $C23C\ 14/08^{(2006.01)}$
$C23C\ 14/16^{(2006.01)}$    $C23C\ 14/20^{(2006.01)}$
$C23C\ 14/34^{(2006.01)}$    $C23C\ 14/35^{(2006.01)}$
$C23C\ 14/56^{(2006.01)}$    $B32B\ 17/10^{(2006.01)}$
$C03C\ 17/36^{(2006.01)}$    $G02B\ 5/28^{(2006.01)}$

(52) Cooperative Patent Classification (CPC):
**C23C 14/165; B32B 17/10036; B32B 17/10174;
B32B 17/10229; B32B 17/10449; B32B 17/10761;
B32B 17/1077; B32B 17/10788; B32B 17/10807;
C03C 17/36; C03C 17/3644; C03C 17/3657;
C03C 17/3681; C23C 14/0036; C23C 14/08;**
(Cont.)

(86) International application number:
**PCT/EP2023/056025**

(87) International publication number:
**WO 2023/170214 (14.09.2023 Gazette 2023/37)**

(54) **IMPROVED PRODUCTION OF AN ENERGY-REFLECTING COMPOSITE**

VERBESSERTE PRODUKTION EINES ENERGIE-REFLEKTIERENDEN VERBUNDSTOFFS

PRODUCTION AMÉLIORÉE D'UN COMPOSITE REFLÉTANT L'ÉNERGIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **09.03.2022 EP 22161187**

(43) Date of publication of application:
**15.01.2025 Bulletin 2025/03**

(73) Proprietor: **MICHIELS GROUP
9240 Zele (BE)**

(72) Inventors:
• **STRIJCKMANS, Koen**
9250 Waasmunster (BE)
• **DEPLA, Diederik**
9250 Waasmunster (BE)
• **MICHIELS, Luc**
9250 Waasmunster (BE)

(74) Representative: **Gevers Patents
De Kleetlaan 7A
1831 Diegem (BE)**

(56) References cited:
**US-B2- 9 034 459**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
**C23C 14/083; C23C 14/205; C23C 14/34;**
**C23C 14/35; C23C 14/562; C23C 14/568;**
**G02B 5/282;** B32B 2419/00; B32B 2457/12;
B32B 2571/02; B32B 2605/00; B32B 2605/08;
B32B 2605/10; B32B 2605/12; B32B 2605/16;
B32B 2605/18

## Description

FIELD OF THE INVENTION

The present invention relates to the production of visually transparent, infra-red reflecting objects comprising a dichroic filter, also known as an interference filter, often addressed as a "stack" because of the sequence of different layers that it typically comprises. The interference stack may be tuned to selectively reflect heat, i.e. infra-red radiation, while transmitting most of the visible light. The object may for instance be a polymeric film or glass plate upon which the stack is deposited as a coating, and such a film or glass plate may for instance be useful as heat mirror for solar heat control with windows in vehicles or buildings. More particularly, the invention relates to an improved process for producing a product offering improved product properties.

BACKGROUND OF THE INVENTION

Heat-mirrors that reflect radiation in the infrared spectrum while transmitting radiation in the visible spectrum have important applications for example as windows in buildings or vehicles. For transparent heat-mirrors, visual light transmittance must be high, and hence the reflectivity and absorptivity must be low. In the infrared, however, the heat-mirror must have high reflectivity and so transmittance and absorptivity in the infra-red must be low. Heat-mirrors comprising a stack of alternating dielectric and metal layers are known in the art.

The interference stack or filter suitable for reflecting heat and/or energy shielding, is typically at most only a few hundred nanometres thick and any physical strength of the overall object must be provided by the substrate that is supporting the stack.

An interference stack suitable for use as heat mirror may be obtained by the use of sputter deposition onto a transparent substrate. The applicants prefer to use magnetron sputter deposition for depositing the subsequent layers because this technique has been found the most useful for applying thin film deposits of uniform thickness over large surface areas.

Briefly, magnetron sputtering involves transporting a substrate through a series of low pressure zones (or "chambers" or "bays") in which the various film regions that make up the coating are sequentially applied. Metallic films are sputtered from metallic sources or "targets," typically in an inert atmosphere such as argon. To deposit transparent dielectric film, the target may be formed of the dielectric itself (e.g., zinc oxide or titanium oxide). The dielectric film may also applied by sputtering a metal target in a reactive atmosphere. To deposit zinc oxide, for example, a zinc target can be sputtered in an oxidizing atmosphere; silicon nitride can be deposited by sputtering a silicon target (which may be doped with aluminium or the like to improve conductivity) in a reactive atmosphere containing nitrogen gas. Fairly common is also the use of suboxide targets, in combination with a reactive atmosphere. A layer of titanium oxide is often obtained using a suboxide target with formula $TiO_x$ in combination with oxygen presence in the sputtering chamber. More details follow later in this document. The thickness of the deposited film may be controlled for instance by varying the speed of the substrate and/or by varying the power on the targets.

The interference filter typically has a multilayer structure which may be constructed by sequentially applying the various layers onto the support. The most simple dichroic filter consists of a thin metal layer that is sandwiched between two layers of dielectric material that is characterised by a high refractive index. This structure is able to bring the property of preferentially passing energy of certain wavelengths and reflecting energy of other wavelengths. The structure is most commonly made suitable for transmitting visible light and reflecting electromagnetic radiation in the infrared region, hence for forming a structure that to the human eye looks transparent but is able to reflect heat, e.g. as part of solar radiation.

It is believed that the effect is caused by an interaction between the incoming radiation and the cloud of free electrons in the metal layer(s), whereby radiation in some wavelengths is slowed down relative to other wavelengths. But also the dielectric layer plays an active role. The metal layer alone would have a much lower transmittance of visible light and would thus be readily noticeable by the human eye. The dielectric layers allow a significant part of that lost transmittance to be regained in the wavelength range of visible light.

The layer of dielectric material may also be called a spacer layer or a boundary layer. The boundary layer(s) offer physical protection to the metal layer, but also reduce visual reflections from the metal layer beneath them.

Dielectric materials, also known as "dielectrics", are non-metallic materials which are transparent to both visible and infrared radiation. Some documents state that organic polymers are also suitable for this purpose, but the applicants prefer by far to use inorganic oxides because of their high refractive index. The preferred thickness of the boundary layer(s) depends on the index of refraction of the dielectric employed, but also on the choice of metal in the metal layer. A higher refractive index material needs a lower layer thickness for obtaining the same effect.

Once the materials for the different layers are selected, the selectivity of the dichroic filter with respect to reflected and transmitted wavelengths is primarily set by the thicknesses of the different layers. The slope of the cut-off between the transmitted and reflected regions in the wavelength spectrum is also affected by the dielectric layers in conjunction with the metal layer. Ideally the thicknesses of the dielectric layers should thus be chosen to provide an optimum balance between desired infra-red reflectance and desired visible radiation transmittance. And the thicknesses of the metal layers should also be suitably chosen. Achieving the intended thicknesses for the different layers and the intended micro-structure of the deposited layers over the full surface of an object is however a daunting task for any of the suitable application techniques, even for the preferred magnetron sputter deposition technique.

The spectrum of solar radiation is for convenience divided into several regions or ranges of wavelengths.

In this document, the band of visible light is considered to cover the range from 380 nm up to 780 nm. Within the visible light range, particular subranges may be of possible relevance, for instance the blue light range (440-490 nm), the red light range (620-700 nm) and the far red light range (700-780 nm).

The industry concerned with energy shielding, heat mirroring and the like, considers the transmittance of visible light through the objects that it provides or uses as an important characteristic, if not the most important property. This is probably because an excessive reduction in the visible light transmittance through an object is readily noticed by the human eye and often affects the human who observes this. The industry has for that purpose adopted a parameter identified as "Visible Light Transmittance" or "VLT" as a standard practice to express this property. This is explained in detail in the Industry Standard NEN-EN 410, of which the applicants prefer to refer to the 2011 edition. According to this industry standard, the value of the VLT parameter is calculated using a transmittance spectrum that is measured for the object over the range of 380 to 780 nm and weighing these transmittances as measured in the subsequent intervals of 10 nm wavelength width in accordance with the values in Table 1 of NEN-EN 410, which are giving in function of the wavelength interval the normalized relative spectral distribution of illuminant D65 multiplied by the spectral luminous efficiency and by the wavelength interval. The CIE standard illuminant D65 is a standard illuminant defined by the International Commission on Illumination (CIE). It corresponds roughly to the average midday light in Western Europe/-Northern Europe, comprising both direct sunlight and the light diffused by a clear sky. The CIE positions D65 as the standard daylight illuminant, intending to represent average daylight. Industry standard ISO 9050 also uses the illuminant D65 with the same weighing factors for its definition of the VLT parameter.

It may be observed however that the weighing applied in determining the VLT of an object gives much less weight to the transmittances in the blue light range (380-490 nm) and in the red and far red light range (620-780 nm), in comparison with the intermediate colours, in particular the green light range. In applications for which the blue and the red light ranges are important, the relevance of the VLT parameter may thus be limited. This may for instance be the case in greenhouse agriculture, where green light has hardly any relevance for crops and plants, but red and blue lights do matter much more.

The solar radiation at sea level typically has the following energy distribution:

|  | Wavelength range (nm) | % of total |
|---|---|---|
| Ultraviolet (UV) | 280-380 | 5% |
| Visible light | 380-780 | 45% |
| Near Infra-red (N-IR) | 780-2500 | 50% |

The ultraviolet range is often further split into UVa (315-380 nm) and UVb (300-315nm). The sun also emits UVc radiation, in the range of 200-300 nm, but that range is in most areas already completely filtered out by the earth atmosphere and therefore does in the areas of interest for agriculture typically not reach the earth surface. UVb radiation, in the range of 300-315 is mostly (but not fully) blocked by traditional float glass that is used to make windows and greenhouses, as well as by some polymer films, such as polyethylene terephthalate (PET), but this is not necessarily so with some other polymers, such as polyethylene (PE), which is a popular polymer for making polytunnels.

Full infra-red (IR) radiation is defined as the radiation in the wavelength range from 780 nm up to 1 mm. This wide range is conveniently further divided into IR-A (780-1400 nm), IR-B (1400-3000 nm) and IR-C (3000 nm - 1 mm). Another convenient split is to divide the IR radiation range into near-infrared (N-IR or NIR, for the range from 780 up to 2500 nm), and-far infrared or long-infrared (L-IR or LIR), for anything above 2500 nm. The radiation in this long-infrared range is the heat that we feel from a fire or a heat source.

The energy distribution of the solar radiation has shown that by far most of its non-visible radiation energy is with wavelengths in the NIR range, whereby the IR-A range prevails. The wavelength range of 780-1400 nm, or the what narrower range of 780-1100 nm, is thus particularly important. The energy in sunlight at sea level tapers down with increasing wavelengths and hardly contains any energy contribution anymore in the wavelength above 2500 nm. It remains however also important to consider the radiation in the UV wavelength range, at the opposite side of the solar spectrum. The radiation in this range is particularly energy intensive, and some of this radiation may be particularly harmful, as explained herein above.

This document will be adhering as much as possible to these definitions of wavelength ranges, but other documents may work with (usually slightly) different wavelength ranges.

Solar radiation has a major part of its non-visible radiation energy with wavelengths in the NIR range, whereby the IR-A range prevails. The wavelength range of 780-1100 nm is thus particularly important. The energy in sunlight at sea level tapers down with increasing wavelengths and hardly contains any solar radiation in the wavelength above 2500 nm.

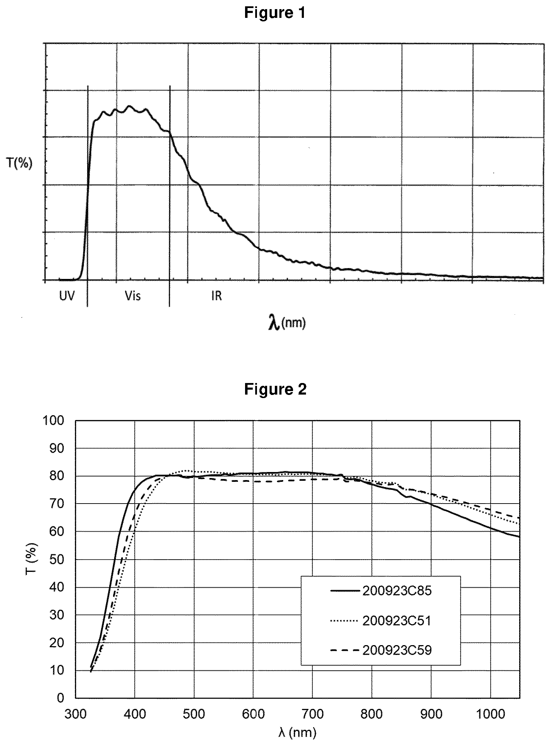

Figure 1 shows a transmittance spectrum that is typical for most conventional composites comprising a dichroic filter. The graph shows the percent transmittance ("T") of the radiation through the composite in function of the wavelength ("λ") of that radiation. On the graph are also roughly indicated the ranges for respectively the ultraviolet ("UV"), the visible ("Vis") and the infrared ("IR") wavelengths. The curve shows the very typical spectrum shape which is characterised by a broad area of high transmittance in the visible light range, in between a very much lower transmittance in the UV range and a more slowly declining transmittance moving into and through the IR range. The transition from low to high transmittance is thus typically quite sharp at the left end of the visible light, where UV-radiation borders the blue-indigo-violet side of the visible light range. The curve is however much less steep at the other end of the visible light range, where the red light end borders with the NIR range.

In view of the desired performance of the filter, i.e. a combination of a high VLT with a high IR reflection, the desire is to maximize the transmittance in the visible range and to minimize the transmittance in the infrared range. Because of the only slow downward slope of a typical curve around the transition point from visible to IR wavelengths, lowering the curve in the IR range usually also simultaneously lowers the VLT, which is undesired. The reduction of the transmittance in the visible light range may be more pronounced in the red light range, i.e. closer to the transition point. This often results in an increased reflection of red light, which then causes the composite to show a reddish colour reflection, which is also undesired.

A growing need exists for composites of a transparent substrate provided with at least one dichroic filter that gives the composite a high visual light transmittance (usually expressed as the VLT parameter explained herein above), while still offering a satisfactory infra-red reflection, preferably a low transmittance in the near-infra-red radiation because this is by far the highest contributor to the heat that is directly transmitted by solar radiation. For instance in the automotive industry, a VLT parameter of at least 70% is mandated in the USA and the EU for vehicle windscreens, and sometimes even 75% may be prescribed. It is known that a thinner metal layer in the interference filter usually allows a higher VLT performance to be obtained, but thinning the metal layer readily creates other problems, because the physical integrity of that metal layer may be quite readily lost.

Adding an extra dichroic filter, interference filter or stack onto the composite may result in a gain by a lower transmittance in the NIR range of importance, but this comes at a cost because it is also causing a reduction of the VLT.

There therefore remains a need for production methods that are able to reduce the transmittance in the near infrared range while minimizing any simultaneous reduction of the VLT.

The present invention aims to obviate or at least mitigate the above described problem and/or to provide improvements generally.

US 9 034 459 B2 relates to solar control films and glazing, including vehicular glazing. The films have a high visible light transmittance, are highly infrared reflective and exhibit a low total solar heat transmission. The solar control film includes flexible support in the form of a visible light-transmissive plastic film (made, for example, from polyethylene terephthalate ("PET")) and a stack of layers atop support. The stack of layers includes a first nucleating oxide seed layer (made, for example, of zinc oxide), a first metal layer (made, for example, of silver), an organic spacing layer (made, for example, from a crosslinked acrylate), a second nucleating oxide seed layer (also made, for example, of zinc oxide) and a second metal layer (also made, for example, of silver). A protective polymer layer (made, for example, from a crosslinked acrylate) lies atop the second metal layer. The first nucleating oxide seed layer, the first metal layer, the second nucleating oxide seed layer and the second metal layer are deposited sequentially onto the support by sputter-deposition. Reactive gases, such as oxygen or water, may be introduced the deposition apparatus to bring about intentional interference to convert a metal layer to an oxide layer.

SUMMARY OF THE INVENTION

According to the invention, there is provided a method as defined in any one of the accompanying claims.

In an embodiment, the invention provides for a method for the production of a visual light transmitting and infra-red reflecting composite including, adhered to one side of a transparent support, at least one dichroic filter (DF) which filter comprises at least one metal layer that is sandwiched in between two layers of dielectric metal oxide, dielectric inorganic compound or dielectric inorganic salt,

wherein the layers of the dichroic filter are deposited sequentially onto the transparent support using sputter-deposition in at least one sputtering chamber, wherein the process comprises, in the sputtering chamber where at least one of the dielectric layers is sputtered, the introduction of at least one inert gas and water,
**characterised in that** the molar flow of the water that is introduced into the sputtering chamber is in the range of 1% to 30% relative to the total molar flow of inert gas that is introduced into the same sputtering chamber, typically about 10%.

The composite may be obtained by the use of sputter deposition onto a transparent substrate. The applicants prefer to use sputter deposition for depositing the subsequent layers because this technique has been found the most useful for applying thin film deposits of uniform thickness over large surface areas.

Sputter deposition is a physical vapour deposition (PVD) method by which a thin film is deposited by sputtering, a technique that involves the ejection of material from a "target", i.e. the source of the material, onto a "substrate". The present invention prefers to use the technique that is called "magnetron sputtering deposition", a technique that is applied under vacuum and using one of known magnetron options including the AC, DC, and pulsed DC versions, but also HiPIMS (High Power Impulse Magnetron) and RF sputtering are suitable.

Sputter deposition is preferably performed in a closed apparatus and under vacuum. Preferably the system provided for pulling and maintaining the vacuum is kept in operation throughout the entire deposition process. Preferably an inert gas is continuously introduced throughout the full deposition process. Replacing the air in the apparatus by an inert gas brings the advantage that an inert gas is more stable under high energy conditions, and because of the inert nature of the gas less to no interaction is expected between the sputtered compounds ejected from the target and the atmosphere inside the sputtering chamber. The result is a better controllability of the process and possibly also a higher yield of the desired compound on the substrate.

The method according to the present invention prescribes that a quantity of molar flow of water should be introduced within a range relative to the amount of inert gas that is introduced into the same sputtering chamber. The applicants have found that controlling the flow, either by weight or by volume or molar, of the inert gas, of the water and of other reactive compounds entering the sputtering chamber is a very convenient and also accurate way for controlling the atmosphere inside the sputtering chamber. The applicants have found that the process is conveniently responsive to changes in the relevant flow or flows such that the process may at least partially be steered by this control method.

US 9034459 B2 describes a film that comprises, formed on a visible light-transmissive support such as polyethylene terephthalate (PET), a so-called "optical" stack containing a first metal layer, an organic spacing layer atop the first metal layer, and a second metal layer, wherein the thicknesses of the metal layers and the spacing layer are such that the film is visible light transmissive and infrared-reflective. The organic spacing layer is preferably consisting of a cross-linked organic polymer. For use in an infrared-rejecting interference stack, the spacing layer may for example have a refractive index of about 1.3 to about 1.7, an optical thickness of about 75 to about 275 nm, and a corresponding physical thickness of about 50 to about 150 nm. In addition, a first and a second nucleating oxide seed layer, formed as a series of small islands, are provided before forming each one of the corresponding two silver metal (Ag) layers. Suitable seed layer oxides are listed as gallium oxide, indium oxide, magnesium oxide, zinc oxide, tin oxide and mixtures thereof, including doped oxides such as zinc oxide doped with aluminium or aluminium oxide. The seed layers and the metal layers were formed by sputtering. The apparatus in which the sputtering is done can be enclosed in a suitable chamber and maintained under vacuum or supplied with a suitable inert atmosphere in order to discourage oxygen, water vapor, dust and other atmospheric contaminants from interfering with the various pretreatment, coating, crosslinking and sputtering steps. The document suggests in column 4, line 64, that reactive gases (e.g., oxygen or water vapour) may be introduced into the apparatus "to convert a metal layer to an oxide layer". This statement implies that the oxygen or water should be introduced once the metal layer has already been formed, but before the deposition of the next layer. The introduction of any reactive gas in connection with the coating of a metal oxide layer was however not possible in the examples of US 9034459 B2, because each time the zinc oxide nucleating seed layer was formed, in the same pass made through the apparatus also the corresponding subsequent silver metal layer was coated, and the document lists for the latter that oxygen and water vapour are atmospheric contaminants of which the presence should be "discouraged". This is quite understandable because, when it is the purpose to deposit a pure metal or metal alloy layer, any presence of other reactive components should be kept as low as possible.

The applicants have surprisingly found that the method according to the present invention is able to shift the transmittance spectrum of the composite to the left, in other words towards lower wavelength ranges, as compared to the transmittance curve that may be registered without the introduction of water into the sputtering chamber. The applicants have found that the region of high transmittance in the spectrum may actually be broadened as compared to the spectrum without the water addition. The applicants have found that the present invention also allows the improved transmittance spectrum and its associated benefits to be maintained throughout a long production run, such as a production run of at least one hour long, preferably at least 2 hours long, more preferably at least 3, 4, 5, 6, 7 or 8 hours long, even more preferably at least 12, 16, 20 or 24 hours long, and optionally at least 30, 36, 42 or 48 hours long.

The applicants have found that the method according to the present invention is thus able to bring as an effect a significant reduction in the transmittance of the IR radiation by the composite, with a major effect being realized in the NIR range, while the visible light transmittance (VLT) of the composite remains high and may even show an increase.

The applicants have surprisingly found that the present invention results in a composite comprising at least one dichroic filter (DF) that is able to establish a highly beneficial combination of a high visible light transmittance (expressed by the "VLT" parameter explained herein before) with a reduced transmittance in the near-infrared wavelength region, characterised by a reduced transmittance in the wavelength range from 900 to 1000 nm, herein represented by the symbol("T_IR").

Without wanting to be bound by this theory, the applicants believe, in the sputtering chamber and under influence of the high level of energy that is present therein, that the water molecules are setting free atoms, radicals or ions of hydrogen, oxygen or hydroxyl, and that the presence thereof results in a significant increase in the number and the dispersion of electron-rich spots on the surface of the dielectric layer, such that the next applied layer, typically the metal layer or an extra intermediate layer, finds more anchoring or nucleation points for its atoms where the metal atoms may find a comfortable rest position and stop moving. The applicants further believe that the presence of water changes the optical properties of the metal oxide layer, possibly by changing its crystal structure, and it is believed to also affect the structure of the subsequent layer that is deposited on the metal oxide layer. The applicants believe that this results in a visible light transmittance that may be measurably higher, at a high level that may be maintained even if more oxygen is introduced in order to broaden the region of high transmittance on one or even both sides of the visible light spectrum, i.e. the indigo-violet side and/or the red side of the region of high transmittance.

Visible Light Transmittance ("VLT") is a directly measurable property. Also Visible Light Reflectance may be measured directly. From these two measurements, the compliment may be calculated and is then the % of visible light that is absorbed. The applicants prefer to establish the VLT of a composite in accordance with Industry Standard NEN-EN 410 - 2011, whereby the transmittance spectrum is weighted as for the illuminant D65 reference (Table 1 of EN 410, wavelength range 380-780 nm).

The applicants have found that the feature specifying a limitation of the transmittance in the wavelength range from 900 to 1000 nm ("T_IR") in accordance with some embodiments of the present invention translates, for a composite comprising at least one dichroic filter, very well in a limited transmittance in the IR region and in particular in the N-IR region. Because the absorption of the composite is typically also small, a lower transmittance also translates inherently and unambiguously, in a higher reflection, which is in view of the technical effect of the present invention particularly relevant in the IR region, more especially in the N-IR region. This relationship is particularly valid when the transmittance spectrum exhibits a shape that corresponds substantially with the general transmittance spectrum of a heat mirror.

The transmittance characteristics of the composite produced according to the present invention may be determined based on a transmittance spectrum that is obtained by means of a suitable spectrophotometer and in accordance with Industry standard NEN-EN 410, edition 2011. More conveniently the characteristics may also be determined by means of a Solar Spectrum Transmittance Meter model number SS2450 obtainable from the company Electronic Design to Market, Inc. (EDTM), based in Toledo, Ohio, USA and when using for VLT and the T_IR the weighting as specified in accordance with standard EN 410-2011. The older models SD2400 and WP4500 are by the same supplier also considered suitable for determining the main transmittance characteristics of the composite produced according to the present invention.

In an embodiment of the present invention, the dichroic stack is highly suitable to serve as an energy shield, for instance for keeping heat energy from the sun out of buildings and vehicles, while minimizing any comfort loss in terms of visible light transmittance.

The applicants have found that the composite produced according to the present invention therefore may bring an increase in the comfort level and/or a reduction of the stress levels that is experienced by living creatures inside enclosures in which the incoming daylight is at least partially passing through the composite produced in accordance with the present invention.

The applicants have found that the use of the composite produced according to the present invention brings yet another significant benefit that is not related to the solar radiation. Heat is emitted by radiation by most common objects. This heat radiation is almost exclusively in the form of radiation in the Long Infrared (LIR) range, i.e. radiation with a wavelength from 2500 nm up to as high as 1 millimetre (mm). This radiation is the heat that we feel from a fire or a heat source. All objects participate to some degree in this phenomenon and are sources of radiation in this wavelength range. So is every surface on the inside of enclosures like buildings, vehicles, greenhouses and polytunnels. The applicants have found that when an enclosure sees little or no sunlight, which is primarily the case at night, but also in the twilight periods of the day, i.e. during dawn and dusk, high amounts of energy may escape by radiation from the enclosure towards the environment through the windows of the enclosure.

The applicants have found that the composite produced according to the present invention also establishes a very low transmittance of radiation in the long infra-red wavelength range of 2500 nm to 1 mm.

When used in the context of an office environment, the composite is able to form some kind of a "heat trap" and keep more of the heat radiation inside. This strongly reduces the heat loss to the environment, and hence reduces the energy requirements for maintaining a comfortable temperature for the workforce inside the office. This means that the present invention may also bring energy savings and a reduction of the "carbon footprint", hence that it makes a contribution to the global climate change challenge. Another advantage is that the atmosphere in an unheated office remains warmer at night or during colder days, hence shorter heating periods and less energy will be needed afterwards for bringing the inside temperature back to the required level, e.g. after weekends or other periods without heating. This may also result in the human work force faster enjoying a comfortable office environment and hence faster feeling more comfortable and hence being more productive.

Also animal shelters and stables may benefit from the composite produced according to the present invention. Most of the intensive livestock rearing has already become anti-seasonal, meaning many of the stables have heating equipment and some even air conditioning for during the hot seasons or in the hotter regions of the world. The energy and carbon footprint benefits explained above with relation to humans in an office environment also apply to animals under shelter or in stables. A better control of the temperature inside an animal shelter or stable brings the further advantage that the animals experience less stress. This has as a result that the animals feed better and hence develop faster and stronger. It also has the result that the animals develop less aggression, which reduces the rate of occurrence of injuries inflicted by one animal to another one, such as picking wounds observed with poultry under stress, or tails that are being bitten of by pigs under stress. The reduced injury rate reduces the need for the use of antiseptic treatments and/or the inclusion of antibiotics into the animal feeds. This reduces the occurrence of traces of those chemicals, in particular of antibiotics, in the meat and eggs obtained from the animals.

Also in the cultivation of plants and crops, the composite produced in accordance with the present invention bring benefits. Thanks to the dichroic filter in the composite, much less heat is generated upon impact of the filtered solar radiation on anything inside the enclosure, such as on plants and soil, and on other objects inside a shelter, stable, greenhouse or polytunnel. This reduces in the first place the requirements for ventilation, and where the suitable equipment is available also for air conditioning, i.e. the conventional measures known for keeping lower the temperature on and around the livestock or plants that are kept or cultivated underneath the composite. The present invention is thus able to bring a reduction in the energy consumption associated with ventilation and air conditioning in agriculture. And a lower energy consumption brings a reduced carbon footprint to the operation. The present invention therefore represents another contribution to the global climate change challenge.

The composite produced according to the present invention may also bring further benefits in an improved control of the microclimate inside agricultural enclosures, such as stables, animal shelters, and greenhouses, as well in polytunnels as in glass greenhouses.

In moderate climate areas like The Netherlands, the lack of sunlight radiation during the darker periods of the year is often supplemented by additional artificial light for specific anti-seasonal crop growth, e.g. for boosting long stemmed red rose supply in the middle of the winter season, such as by Valentine's day (Feb 14). These developments are increasingly using LED-lighting, whereby the wavelength of the LEDs are chosen in function of the plant species and if possible also in function of the particular development stage that the species is in. A major drawback of this approach is that it further increases the investment cost and the energy consumption, as well as the carbon footprint of the activity. Another drawback is that this approach only provides a means to supplement solar radiation, but provides no increase in the protection against the negative parts of solar radiation. During heat waves, there remains the need for a shading agent, usually the conventional white coating, which is non-selective in reflecting radiation and thus also reflects part of the useful sunlight that plants need for their development. It has been observed that plants underneath such a white shading agent tend to go into some kind of a stretching mode, forming longer stems in order to seek more light, which usually comes at the expense of leaf formation, flowering, fruit setting and fruit development.

The applicants have found that the composite produced according to the present invention is able to improve the microclimate inside agricultural enclosures by providing a protection against the wavelength ranges in sunlight that are harmful to and/or represent the major cause of heat input towards the inside of the enclosure, and preferably in combination with for plants an improved alignment of the wavelengths of the radiation in the photo active radiation (PAR) that is allowed to reach the plants with the specific needs of the plant, more preferably the specific needs during the particular development stage that the plant is in. The composite is able to bring these benefits while avoiding the high investment and operating costs, and the environmental and/or climate effects that are associated with the protection and control options that are currently known in the art.

The applicants have found that a major advantage brought by the composite produced according to the present invention is a significant reduction of the transmittance of the part of the solar radiation that only contributes to the generation of heat inside the enclosure underneath the composite. This part of the solar radiation is primarily situated in the near infrared region of the solar radiation spectrum.

The composite that is produced in accordance with the present invention comprises at least one dichroic filter (DF). Such a filter is characterised by a transmittance spectrum that exhibits a downward slope with increasing wavelengths in the infrared region, i.e. above 780 nm, and which spectrum continues to slope down all throughout the infrared region. We have seen above that half of the energy in the solar radiation at sea level comes with radiation in the near infrared wavelength range. We have also seen above that animals, crops and plants make no significant use of the radiation in that wavelength range, but that this radiation is the major contributor of heat generated by solar radiation. The applicants submit that therefore a reduction of the radiation in the near infrared wavelength range is a very important and desired property of any object that has the intention of affecting the solar radiation that is passing through it. It is therefore also a prime target property to be provided by the composite that is produced according to the present invention. The applicants have found that the transmittance performance in the infrared wavelength range at large, and of the transmittance in the near infrared wavelength range in particular, of the composite that is produced according to the present invention, may conveniently be represented by the transmittance in the wavelength range from 900 to 1000 nm, which is in this document conveniently defined as "T_IR". The advantage is that the transmittance in the range from 900 to 1000 nm is readily measurable by simple equipment, such as for instance by the Solar Spectrum Transmittance Meter model # SS2450 from the company EDTM from Ohio, USA. Because of the continuing downward slope of the transmittance curve of a composite containing at least one dichroic filter with increasing wavelengths in the near infrared wavelength and beyond, the applicants have found that the T_IR is an excellent indicator for the transmittance performance of the composite over the entire infrared wavelength range at large, and in the near infrared wavelength range in particular.

For these reasons, the applicants have found that the T_IR is a very convenient parameter for characterizing the composite that is produced as part of the present invention for use in agriculture. The applicants have found that the composite is excellently suitable for a use for the conditioning of solar radiation incident on crops, such as in agricultural enclosures dedicated for crops or plant development, such as greenhouses in any suitable form or shape, including glass greenhouses and polytunnels, but also for the conditioning of solar radiation entering an animal shelter or stable.

The applicants have found that the limited T_IR of the composite that is used according to the present invention brings significant advantages to the user.

Thanks to the dichroic filter in the composite, much less heat is generated upon impact of the filtered solar radiation on anything inside the enclosure, such as on plants and soil, and on other objects inside a shelter, stable, greenhouse or polytunnel. This reduces in the first place the requirements for ventilation, and where the suitable equipment is available also for air conditioning, i.e. the conventional measures known for keeping lower the temperature on and around the livestock or plants that are kept or cultivated underneath the composite. The present invention is thus able to bring a reduction in the energy consumption associated with ventilation and air conditioning in agriculture. And a lower energy consumption brings a reduced carbon footprint to the operation. The present invention therefore represents a contribution to the global climate change challenge.

A better control of the temperature inside an animal shelter or stable brings the advantage that the animals experience less stress. This has as a result that the animals feed better and hence develop faster and stronger. It also has the result that the animals develop less aggression, which reduces the rate of occurrence of injuries inflicted by one animal to another one, such as picking wounds observed with poultry, or tails that are being bitten off by pigs under stress. The reduced injury rate reduces the need for the use of antiseptic treatments and/or the inclusion of antibiotics into the animal feeds. This reduces the occurrence of traces of those chemicals, in particular of antibiotics, in the meat and eggs obtained from the animals.

In botany, a stoma (plural "stomata"), also called a stomate (plural "stomates") is a pore, found in the epidermis of leaves, stems, and other organs, that controls the rate of gas exchange, what is often called "the stomatal conductance". The pore is bordered by a pair of specialized parenchyma cells known as guard cells that are responsible for regulating the size of the stomatal opening.

The term is usually used collectively to refer to the entire stomatal complex, consisting of the paired guard cells and the pore itself, which is referred to as the stomatal aperture. Air enters the plant through these openings by gaseous diffusion. The air contains carbon dioxide which is used in photosynthesis and oxygen which is used in respiration. Oxygen produced as by-product of photosynthesis diffuses out to the atmosphere through these same openings. Also, water vapour diffuses through the stomata into the atmosphere in a process called transpiration.

The present invention also keeps lower the temperature of the different parts of the cultivated plants, such as the stem and the leaves. A plant reacts to excessive heat in the first place by extra transpiration, i.e. by further opening the stomata on the plant surfaces such that more water is able to evaporate and extract the heat for that evaporation from the plant. Most of this extra water vapour inside the greenhouse typically leaves via the ventilation system. It is lost to the environment and needs to be replenished by irrigation. The present invention is therefore able to bring the advantage of a reduced water loss, and hence a reduction in the water consumption in agriculture.

When a plant is exposed to more than comfortable levels of heat, the plant goes into stress mode. It puts more, and eventually all, of its efforts into survival, and this comes at the expense of biomass growth, impacts on the flowering, and an impairment of the setting and development of fruit. By the protection against overheating, the present invention brings the benefit of increased biomass growth, and with fruit-bearing crops an increased number and weight of fruits.

When the temperature on the surfaces of the plant stem and leaves raises further and the transpiration of the plant is unable to control the temperature rise, the plant moves into a kind of traumatic response, a process that may be called "necrosis". The plant starts to sacrifice cells, usually at leave edges or shoot tips. Cell walls rupture and the content of the cell is released, which results in premature death of the cells. Because the dead cells have lost their chlorophyll pigments, their colour turns yellow and subsequently even brown. The appeal of the plant as a commercial product is thereby quickly lost. The plant has become unsaleable. If the stress continues, the plant eventually dies off completely. As soon as the plant has lost its appeal, the commercial product has turned into an unsaleable waste that needs to be removed from the soil and disposed of, and the soil may even need to be cleaned and/or replaced, and its fertilizer content should be brought up again. The operating costs already spent on seeds, fertilizer, irrigation, ventilation and/or on "Heating, Ventilation and Air Conditioning" (HVAC) are wasted, and the return on the investment in the greenhouse is reduced. In addition comes the cost for returning the soil into again arable surface for a new crop. What was intended as a commercial product and a source of income has converted into an extra cost burden for the crop grower.

The composite as part of the use brings the advantage that a significant part of the solar radiation that forms the main contributor to the heat that is generated inside an agricultural enclosure underneath the composite is not transmitted, and therefor does not reach the plant, nor any other internal object or surface. The present invention was found to strongly reduce the occurrence that plants that are protected by the composite against solar radiation move into necrosis. The applicants have found that the composite produced according to the present invention provides an excellent protection against excessive heating of the protected plants, against the stress that is associated with such excessive heating, against the risk and occurrence of necrosis. Because this brings a strong reduction in the loss of commercial products, the present invention brings the benefit of a higher yield

The applicants have found that the use of the composite produced according to the present invention brings yet another significant benefit that is not related to the solar radiation. Heat is emitted by radiation by most common objects. This heat radiation is almost exclusively in the form of radiation in the Long Infrared (LIR) range, i.e. radiation with a wavelength from 2500 nm up to as high as 1 millimetre (mm). Soil and plants, like all other objects, also participate in this phenomenon and are sources of radiation in this wavelength range. And so is every other surface on the inside of enclosures like a greenhouse or a polytunnel. The applicants have found that when an agricultural enclosure sees little or no sunlight, which is primarily the case at night, but also in the twilight periods of the day, i.e. during dawn and dusk, high amounts of energy may escape by radiation from the enclosure towards the environment through the roof and the walls of the enclosure.

The applicants have also found that plants may come under stress when the ambient temperature drops too low. The plant is brought outside of its comfort zone, and also this reduces the rates of biomass growth, flowering and the setting and development of fruit. It is therefore important to minimize or avoid the exposure of plants to temperatures that are below its range of comfort. This may be important during the normal growing season of the plant, during nights, dawn and dusk, and during cloudy and colder days, but it is even much more important in anti-seasonal plant cultivation, when the external temperature may even drop below 0°C and a risk for frost damage may occur. Many of the glass greenhouses in North-Western Europe are for this reason equipped with heating facilities in order to avoid or at least minimize the negative consequences of such exposure.

The applicants have found that the composite that is produced in accordance with the present invention is an excellent reflector for heat radiation. Radiation in the long infrared wavelength range (2500 nm and above) is almost totally reflected by the at least one dichroic filter in the composite. Towards the inside of an enclosure that is properly equipped with the composite, the filter forms an excellent thermal insulator for heat radiation, i.e. some kind of a (radiative) "heat trap". The so-called "low-E" versions of such a composite are even more effective and approach almost a complete reflection of the L-IR radiation. This means that during colder days of the growing season, or in anti-seasonal cultivation, less heating must be provided in order to maintain the temperature in the enclosure above the lower limit of what is experienced as comfortable by the plants. This means that the present invention again brings energy savings and a reduction of the "carbon footprint", hence that it makes another contribution of the present invention to the global climate change challenge. Another advantage is that the atmosphere in an unheated agricultural enclosure remains warmer at night or during colder days during the growing season. This is particularly advantageous for agricultural enclosures that have no external heating installation, such as a polytunnel.

The applicants have also found that the present invention is able to bring the additional beneficial effect of a lower loss of comfort in terms of colour neutrality of the transmitted visible light as well as in the neutrality of the reflected visible light.

The dichroic filters that are already known in the art may suffer from a number of colour related inconveniences.

The pressure to further reduce the transmittance of radiation in the N-IR wavelength range for composites already known in the art often brings a side effect in the red part of the visible light range. Because of the sloping shape of the transmittance spectrum around the transition from visible to NIR radiation, a reduction in the N-IR transmittance often results in a reduced transmittance in the red part of the visible light range, usually bringing along an increased reflection of red light by the composite, resulting in the composite exhibiting a reflection that has a reddish colour. This effect is undesired in many of the applications of the dichroic filter, such as in windows for buildings or vehicles.

Also on the lower end of the visible light spectrum, if the steep part of the transmittance spectrum is located entirely inside the visible light spectrum, e.g. at or close to 500 nm, the filter may show a reflection having a blue-to-purple colour. Also this effect is undesired in most of the applications of the dichroic filter.

In order to avoid this blue/purple colour effect, it is known in the art that the steep climb of the transmittance spectrum at the low end of the visible light spectrum may be moved somewhat to the left by increasing the level of oxygen in the sputtering gas when the titanium dioxide layer is being built. This however also brings down the transmittance spectrum over the entire visible light region, which reduces the VLT of the stack.

The applicants have surprisingly found that the present invention is able to reduce and even to avoid at least one and preferably both of the undesired effects of a colour showing up in the reflection from the composite. The applicants have found that the present invention allows a reddish colour and/or a blue/purple colour in the reflection from the composite to be avoided in combination with the beneficial effects of the present invention already discussed above.

The applicants have further found that the composite produced according to the present invention, when glued on a glass surface, continues to exhibit the same and high Shielding Effectiveness (SE) for electromagnetic radiation in accordance with ASTM D4935 over the frequency of 10 MHz to 1 GHz, i.e. it is able to provide a damping factor that is in the range of 17-22 dB throughout that frequency range. The applicants have thus found that the composite produced according to the present invention may provide highly appreciated performances in architectural shielding and for shielding in automotive applications. The applicants have found that these excellent shielding properties for electromagnetic radiation may be offered in combination with the improved transmittance spectra obtained as part of the present invention.

BRIEF DESCRIPTION OF THE DRAWINGS

Figure 1 shows the general shape of a transmittance spectrum, as percent transmittance vs wavelength in nanometre, for a composite comprising at least one dichroic filter.

Figure 2 shows the transmittance spectrum for a composite containing only one dichroic filter (1DF) and compares the spectrum 200923C85 of a composite produced according to the present invention with two spectra 200923C51 and 200923C59 of highly comparable composites not made according to the present invention.

Figure 3 shows the transmittance spectrum for a composite containing two dichroic filters (2DF) and compares the spectrum 200924C84 of a composite produced according to the present invention with the spectra 200924C50 and 200924C58 of highly comparable composites not made according to the present invention.

Figures 4 and 5 show the transmittance spectra for 1DF composites made with different rates of water addition covering a wide range of water presence.

DETAILED DESCRIPTION

The following detailed description does not limit the invention. Instead, the scope of the invention is defined by the appended claims.

Several documents are cited throughout the text of this specification. Each of the documents herein (including any manufacturer's specifications, instructions etc.) are hereby incorporated by reference; however, there is no admission that any document cited is indeed prior art to the present invention.

The detailed description serves the purpose of describing preferred embodiments of the present invention and is not intended for being a limited representation of the only embodiments in which the present invention may occur or may be applied. The description attempts the clarify the functionalities and the steps that are required for creating the invention and to reduce it to practice. It should be understood that the same or equivalent functionalities and parts may be obtained in or with other embodiments and that also those are intended to be comprised in the scope of the present invention.

The present invention will hereinafter be described in particular embodiments, and with possible reference to particular drawings. The invention is however not limited thereto, it is only limited by the claims. Any drawings described are only schematic and are non-limiting. In the drawings, the size of some of the elements may be exaggerated and not drawn to scale for illustrative purposes. The dimensions and the relative dimensions in the drawings do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than those described and/or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein may operate in other orientations than described or illustrated herein.

By using words for orientation such as "atop", "on, "uppermost", "underlying", and the like for the location of various elements in the disclosed coated articles, we refer to the relative position of an element with respect to a horizontally-deposed, upwardly-facing support. It is not intended that the films or articles should have any particular orientation in space during or after their manufacture.

The verb "to comprise", as used in the claims in its various grammatical forms, should not be considered as being limited to the elements that are listed in context with it. It does not exclude that there are other elements or steps. It should be considered as the presence provided of these features, integers, steps or components as required, but does not preclude the presence or addition of one or more other features, integers, steps or components, or groups thereof. Thus, the volume of "an article comprising means A and B" may not be limited to an object which is composed solely of agents A and B. It means that A and B are the only elements of interest to the subject matter in connection with the present invention. In accordance with this, the terms "comprise" or "embed" enclose also the more restrictive terms "consisting essentially of" and "consist of". By replacing "comprise" or "include" with "consist of" these terms therefore represent the basis of preferred but narrowed embodiments, which are also provided as part of the content of this document with regard to the present invention.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding the understanding of one or more of the various inventive aspects. This method of disclosure, however, is not to be interpreted as reflecting an intention that the claimed invention requires more features than are expressly recited in each claim. Rather, as the claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the claims, any one of the claimed embodiments can and may be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Other embodiments of the invention will be apparent to those skilled in the art from consideration of the specification and practice of the invention disclosed herein. It is intended that the specification and examples be considered as exemplary only. Each and every claim is incorporated into the specification as an embodiment of the present invention. Thus, the claims are part of the description and are a further description and are in addition to the preferred embodiments of the present invention. Every one of the claims sets out at least one particular embodiment of the invention. The following terms are provided solely to aid in the understanding of the invention.

Unless specified otherwise, all ranges provided herein include up to and including the endpoints given, and the values of the constituents or components of the compositions are expressed in weight percent or % by weight of each ingredient in the composition.

As used herein, "weight percent," "wt-%," "percent by weight," "% by weight,", "ppmwt", "ppm by weight", "weight ppm" or "ppm" and variations thereof refer to the concentration of a substance as the weight of that substance divided by the total weight of the composition and multiplied by 100 or 1000000 as appropriate, unless specified differently. It is understood that, as used here, "percent," "%," are intended to be synonymous with "weight percent," "wt-%," etc., unless otherwise specified.

It should be noted that, as used in this specification and the appended claims, the singular forms "a," "an," and "the" include plural referents unless the content clearly dictates otherwise. Thus, for example, reference to a composition containing "a compound" includes a composition having two or more compounds. It should also be noted that the term "or" is generally employed in its sense including "and/or" unless the content clearly dictates otherwise.

Additionally, each compound used herein may be discussed interchangeably with respect to its chemical formula, chemical name, abbreviation, etc..

In the context of the present invention, an interference filter is an optical filter that reflects one or more spectral bands or lines and transmits others, while maintaining a low coefficient of absorption for all wavelengths of interest.

An interference filter consists at least of multiple thin layers of dielectric material having different refractive indices. The filter may also further comprise at least one metal layer. Interference filters are wavelength-selective by virtue of the interference effects that take place between the incident and reflected waves at the thin-film boundaries.

Interference filters are also called dichroic filters. In the context of the present invention, a dichroic filter, also known as a thin-film filter, or often also called an interference filter or a thin-film interference filter, is a wavelength range (or "colour") filter used to selectively pass light of a smaller range of wavelengths compared to what is available, while reflecting other wavelengths. In the context of the present invention, the terms dichroic filter and interference filter are used interchangeably and as synonyms of each other. This document does not follow the more narrow definition in some handbooks in which a dichroic filter is defined as a multilayer structure of high and low index materials. Dichroic filters use the principle of thin-film interference, and produce colours in the same way as oil films on water. Dichroic filters that do not comprise a metal layer do exist, but are considered not to be part of the present invention. An example of such a non-metallic dichroic filter is as follows. When light strikes an oil film at an angle, some of the light is reflected from the top surface of the oil, and some is reflected from the bottom surface where it is in contact with the water. Because the light reflecting from the bottom travels a slightly longer path, some light wavelengths are reinforced by this delay, while others tend to be cancelled, producing the colours seen. Dichroic filters are sometimes also named Fabry-Perot interference filters, or Fabry-Perot (FP) filters, because they are based on the thin film light interference principle that was discovered by Fabry and Perot and which was used to develop the so-called Fabry-Perot interferometer.

In the context of the present invention, parameters reflecting a percent (%) transmittance always relate to a particular wavelength range. The percent transmittance is reflecting the amount of radiation energy within that wavelength range that is able to pass through an object, usually the object being the composite comprising the at least one dichroic filter (DF) or a derivative thereof, relative to the amount of radiation in that same wavelength range that is reaching the object on the impact side of the radiation. In order to keep the different values for % transmittance comparable with each other, the measured transmittance values must be weighted using a selected weighting function and be normalised over the selected wavelength range.

A weighting function used in the context of the present invention is for instance the weighting function for the illuminant D65 reference, to be used as explained in the Industry Standard NEN-EN 410 (2011, English version) and for which the weighting factors are given in Table 1 of the standard. This weighting function is used for instance in determining the % Visible Light Transmittance or "%VLT" of an object. It already gives normalised weighting factors for the transmittance as measured for wavelength increments each having a width of 10 nm wide over the range from 380 to 780 nm.

The visible light transmittance (VLT, usually expressed in %) or $\tau_V$ (expressed as a fraction) of a transparent object is thus calculated in accordance with NEN-EN 410 using the following formula (formula 1 from the standard):

$$\tau_V = \frac{\sum_{\lambda=380\,\text{nm}}^{780\,\text{nm}} D_\lambda \tau(\lambda) V(\lambda) \Delta\lambda}{\sum_{\lambda=380\,\text{nm}}^{780\,\text{nm}} D_\lambda V(\lambda) \Delta\lambda}$$

Whereby in this formula,

$\tau_V$ is the spectral transmittance of the object, expressed as a fraction,
$D_\lambda$ is the relative spectral distribution of illuminant D65 (available in the industry standard as part of the products of ($D_\lambda$ V($\lambda$) $\Delta\lambda$ . $10^2$) from Table 1, hence expressed in percent),
V($\lambda$) is the spectral luminous efficiency for photocopic vision defining the standard observer for photometry, i.e. values that reflect the visual sensitivity of a theoretical human eye, and
$\Delta\lambda$ is the wavelength interval

The parameter VLT, expressed in percent, is then the $\tau_V$ multiplied by 100.

Another weighting function used in the context of the present invention is for instance the weighting function for the UV wavelength range, to be used as explained in the Industry Standard NEN-EN 410 (2011, English version) and for which the weighting factors are given in Table 3 of the standard. The table gives already normalised weighting factors for the transmittance as measured for wavelength increments each having a width of 5 nm wide over the range from 300 to 380 nm. The formula for calculating the transmittance in the UV range in accordance with NEN-EN 410 may be shown as follows (formula 25 from the standard):

$$\tau_{UV} = \frac{\sum\limits_{\lambda=280\,nm}^{380\,nm} U_\lambda \tau(\lambda) \Delta\lambda}{\sum\limits_{\lambda=280\,nm}^{380\,nm} U_\lambda \Delta\lambda}$$

Whereby in this formula,

$\tau_{UV}$ is the UV transmittance of the object to be calculated, as a fraction,
$\tau(\lambda)$ is the spectral direct transmittance of the object, expressed as a fraction,
$U_\lambda$ is the relative distribution of the UV part of global solar radiation (available in Table 3 as the products of $U_\lambda$ with $\Delta\lambda$),
$\Delta\lambda$ is the wavelength interval.

The parameter T_UV, expressed in percent, is then the $\tau_{UV}$ multiplied by 100.

For other transmittance values in the context of the present invention, the applicants prescribe that these may be weighted using the weighting factors for the global solar radiation and which should, if not already available as normalised, be normalised over the specified wavelength range. The applicants use the set of normalised weighting factors for the global solar radiation for wavelength increments each having a width in the range of 20 nm to 100 nm wide over the range from 300 to 2500 nm as given in Table 2 of Industry Standard NEN-EN 410, and which is believed to reflect the solar radiation energy, at sea level and with the sun in the zenith position, presumably including both direct and diffuse solar radiation. Where the percent transmittance in a specific subrange thereof is calculated, the weighting factors from this table for that subrange should again be normalised in order to keep the percent transmittance values comparable to each other.

For the total solar direct transmittance of an object, the following formula should be used in accordance with NEN-EN 410 (formula 10 from the standard as published):

$$\tau_e = \frac{\sum\limits_{\lambda=300\,nm}^{2500\,nm} S_\lambda \tau(\lambda) \Delta\lambda}{\sum\limits_{\lambda=300\,nm}^{2500\,nm} S_\lambda \Delta\lambda}$$

Whereby in this formula,

$\tau_e$ is the solar direct transmittance of the object to be calculated, as a fraction,
$\tau(\lambda)$ is the spectral transmittance of the object, expressed as a fraction,
$S_\lambda$ is the relative spectral distribution of the solar radiation (available in Table2 as the product of $S_\lambda$ with $\Delta\lambda$),
$\Delta\lambda$ is the wavelength interval.

The parameter T_sol, expressed in percent, is then the $\tau_e$ multiplied by 100.

For the other transmittance parameters used in the context of the present invention, i.e. T_IR, T_blue, T_red, T_far red and T_PAR, which all relate to only a particular part of the global solar radiation in terms of their wavelength range, the applicants apply the above formula (10) for T_sol, but then only for the specific wavelength range that is selected for that specific parameter. The parameter in percent is than the result of the value, calculated using the appropriate formula in terms of wavelength range, multiplied by 100.

As already stated elsewhere in this document, the visible light transmittance of the composite, i.e. the energy transmittance in the visible light range, may be directly measurable. More difficult but also directly measurable is the visible light reflectance. From these two measurements, the compliment may be calculated which represents the % of visible light that is absorbed. Radiation energy that is absorbed leads to a heating up of the composite, which causes an increased transfer of heat from the composite to its surroundings, both by radiation and by thermal conduction.

Such radiation of heat from construction materials, such as internals of vehicles and buildings, occurs mostly in the high infrared wavelength region, i.e. at wavelengths of 8000 nm and higher, almost exclusively in the long-infrared wavelength range. It is yet another benefit of the composites produced according to the present invention that they exhibit almost full reflection in this L-IR wavelength range. Because this is the range in which objects inside buildings and vehicles emit their heat radiation. By reflecting substantially all of this heat back towards the inside of buildings and vehicles, the composites produced according to the present invention bring the extra benefit of keeping energy inside buildings and vehicles instead of losing that energy as heat radiation through the windows towards the outside.

The low transmittance of most of the heat from the sun towards the internal of buildings and vehicles, which is radiated in the N-IR range, helps to avoid a possible overheating of the inside of buildings and vehicles and hence saves on the burden of any air conditioning systems installed to keep those insides cool, primarily during summer time. The almost full reflection in the L-IR range strongly reduces the loss of heat by radiation from the inside towards the outside of buildings and vehicles, and hence saves on the burden of any heating systems installed to keep those insides warm, primarily during winter times.

In an embodiment of the process according to the present invention, the molar flow of the water that is introduced is at least 2% relative to the total molar flow of inert gas that is introduced into the same sputtering chamber, preferably at least 3%, more preferably at least 4%, even more preferably at least 5%, yet more preferably at least 6%, preferably at least 7%, more preferably at least 8%, even more preferably at least 9%, yet more preferably at least 10%, preferably at least 11%, more preferably at least 12%, even more preferably at least 13%, yet more preferably at least 14%. Optionally the molar flow of the water that is introduced is at most 28% relative to the total molar flow of inert gas that is introduced into the same sputtering chamber, preferably at most 26%, more preferably at most 25%, even more preferably at most 24%, yet more preferably at most 22%, preferably at most 20%, more preferably at most 18%, even more preferably at most 17%, yet more preferably at most 15%, preferably at most 14, more preferably at most 13%, even more preferably at most 12%, yet more preferably at most 11%. The applicants have found that compliance with these limits assures that the effects brought by the present invention, as explained elsewhere in this document, are achieved and may even be optimised.

Sputtering machines and processes are e.g. disclosed in US 4,204,942, US 2015/0021168 A1 and US 4,799,745.

In an embodiment of the present invention, in the sputtering chamber in which the at least one of the dielectric layers is sputtered, the total pressure is controlled to be at most 0.005 mbar or 0.5 Pa, preferably at most 0.004 mbar, more preferably at most 0.003 mbar, even more preferably at most 0.002 mbar, yet more preferably at most 0.001 mbar, preferably at most 0.0005 mbar, more preferably at most 0.0001 mbar, even more preferably at most 0.00005 mbar, yet more preferably at most 0.00001 mbar.

Preferably the atmosphere in the sputtering chamber is comprising argon as at least one inert gas, more preferably as the at least one inert gas, even more preferably as the major component of the inert gas introduced into the sputtering chamber, yet more preferably as substantially the only inert gas introduced into the sputtering chamber. The applicants have found that argon offers the most suitable combination of a higher molecular weight and a more readily availability.

In an embodiment of the present invention, in the sputtering chamber in which the at least one of the dielectric layers is sputtered, the partial pressure of water is maintained in the range of at least 0.00001 mbar (0.001 Pa) and 0.0015 mbar (0.15 Pa), preferably at least 0.00005 mbar, more preferably at least 0.00007 mbar, even more preferably at least 0.00010 mbar, yet more preferably at least 0.00015 mbar, preferably at least 0.00020 mbar, more preferably at least 0.00030 mbar, even more preferably at least 0.00040 mbar, yet more preferably at least 0.00050 mbar, preferably at least 0.00060 mbar, more preferably at least 0.00080 mbar, even more preferably at least 0.00100 mbar, yet more preferably at least 0.00120 mbar, optionally at most 0.00125 mbar, preferably at most 0.00100 mbar, more preferably at most 0.00090 mbar, even more preferably at most 0.00080 mbar, yet more preferably at most 0.00070 mbar, preferably at most 0.00060 mbar, more preferably at most 0.00050 mbar, even more preferably at most 0.00040 mbar, yet more preferably at most 0.00030 mbar. The applicants have found that respecting the limits as specified for the partial pressure of water in the atmosphere in the sputtering chamber strongly contributes to the optimization of the technical effect brought by the present invention. The applicants have found that controlling the partial pressure of water by means of controlling the total pressure in the sputtering chamber in combination with controlling the molar flows of the inert gas and of the water introduced into the sputtering chamber represents a very convenient, accurate and representative method, and is much more reliable than any attempt to combine a total pressure measurement with a direct measure of the partial pressure of water or an analysis of the atmosphere in the sputtering chamber.

In an embodiment of the present invention, into the sputtering chamber in which the at least one of the dielectric layers is sputtered, in addition to water, oxygen is introduced as a second reactive gas. This allows to assure that the metal oxide in the dielectric layer ends up having the correct composition, regardless of the composition of the target that is used for this sputtering step.

In an embodiment of the present invention wherein oxygen is introduced in the sputtering chamber in which the at least one of the dielectric layers is sputtered, the molar flow of the oxygen that is introduced is controlled in the range of 0.1% to 20% relative to the total molar flow of inert gas that is introduced into the same sputtering chamber. Preferably the molar flow of oxygen, on the same basis, is at least 0.5%, preferably at least 1.0%, more preferably at least 2.0%, even more preferably at least 3.0, yet more preferably at least 4.0%, preferably at least 5.0%, more preferably at least 6.0%, preferably at least 7.0%, more preferably at least 8.0%, even more preferably at least 9.0, yet more preferably at least 10.0%, preferably at least 11.0%, more preferably at least 12.0%, even more preferably at least 13.0, yet more preferably at least 14.0% relative to the total molar flow of inert gas that is introduced into the same sputtering chamber. Optionally the molar flow of oxygen, on the same basis, is at most 20%, preferably at most 15%, more preferably at most 12%, even more preferably at most 10%, yet more preferably at most 9.0%, preferably at most 8.0%, more preferably at most 7.0%, even more preferably at most 6.0%, yet more preferably at most 5.0% relative to the total molar flow of inert gas that is introduced into the same sputtering chamber. The applicants prefer to adapt the amount of oxygen being introduced to the choice of target that is used for depositing the dielectric layer of metal oxide. When metal targets are used, the applicants prefer to introduce more oxygen, preferably in one of the above ranges that are at least 7.0% or any of the subranges thereof that is listed earlier in this paragraph. When oxide targets are used that contain less than the stoichiometric amount of oxygen relative to the amount of metal, so-called "suboxide" targets, the applicants prefer to introduce less oxygen, preferably in one of the above ranges that are at least 0.5% and at most 8.0%, including any subrange thereof that is listed above. As an example, a suboxide target of titanium oxide may be represented by the formula $TiO_X$, whereby x is in the range of 1.5 - 2.0.

Also metal nitrides may be used as the material for the dielectric layers. These can be obtained by using directly the selected metal nitride as the sputtering target, but the metal nitride layer may also be obtained by sputtering a corresponding target of the corresponding metal, pure or in a subnitrided version, and by introducing nitrogen gas into the sputtering chamber. The applicants have found that this operating procedure is highly similar to what we explained in the preceding paragraph with metal oxide layers, and it therefore offers the possibility to steer the degree of nitrogen inclusion into the metal nitride layer. The applicants have found that it is strongly preferred to keep the amount of nitrogen in the finally obtained nitride layers below what would be the stoichiometric amount for saturating the chemical formula of a stable nitride of the metal throughout the layer.

In an embodiment of the present invention, the water is introduced into the sputtering chamber as water vapour. The applicants have found that it is much more convenient to introduce the water as water vapour. The applicants have found that this way the amount of water that is introduced may be much more accurately controlled, such that the composition of the atmosphere inside the sputtering chamber may much more accurately be controlled. This brings the advantage that the technical effect of the present invention may be more readily optimized.

In an embodiment of the present invention, the sputtering chamber in which the at least one of the dielectric layers is sputtered is connected with a side chamber containing an amount of liquid water, the connection preferably being provided with a control valve. Preferably the connection is with the vapour part of the side chamber, such that through the connection only water vapour is introduced, and no significant amounts of liquid water are passing. The control valve brings the advantage that the opening of the control valve may control the rate of addition of water from the side chamber into the sputtering chamber. If the control valve is properly selected, this control method may bring a high control precision. We prefer to use the dosing valve with the reference EVN 116 that was obtained from the company Pfeiffer Vacuum. The flow corresponding to a particular digital position indication on the valve may be obtained from the gas flow curve given for a 1 bar pressure difference, which may then be corrected for the actual pressure drop that is available over the dosing valve. Preferably also the temperature of the water in the side chamber is controlled, such that indirectly this offers a control on the vapour pressure of water that is in equilibrium with the liquid water in the side chamber.

In an embodiment of the present invention wherein a side chamber containing liquid water is used, the side chamber is provided with at least one transparent window or side. This brings the benefit that the presence of liquid water in the side chamber may at all times be visually verified and assured.

In an embodiment of the present invention wherein a side chamber containing liquid water is used, at least two side chambers are provided and preferably both side chambers are individually connected with the sputtering chamber and each of these connections has its own control valve. This brings the benefit that the flow of water that is introduced into the sputtering chamber may be assured at all times throughout a production run. The at least two side chambers may be used alternatingly, such that during use of the first one side chamber a second other side chamber may be disconnected, opened, and its water content be replenished. During these interventions, the first chamber may continue to supply water to the sputtering chamber.

The applicants have found that a constant and continuous introduction of the same amount of water into the sputtering chamber contributes to a good distribution of the desired structure of the dichroic stack, and hence to an achievement of the desired effect over the entire surface of the composite.

In an embodiment of the present invention, the sputtering of the at least one dielectric occurs in a sputtering chamber is different from the chamber wherein the metal layer is sputtered. This brings the benefit that the atmosphere in which the metal layer is sputtered may be controlled more independently from the atmosphere in which the dielectric is sputtered. In a process where also at least one intermediate layer is sputtered, such as a seed layer and/or a blocker layer, the applicants prefer that also any one of these intermediate layers are sputtered in a chamber that is different from the chamber in which the at least one dielectric is sputtered. With this feature, the sputtering of the metal layer, and if relevant also of the seed and/or blocker layer, may be less impacted by the presence of water and/or oxygen in the atmosphere in the sputtering chamber in which the at least one dielectric is performed. The at least one intermediate layer is preferably also a metal layer or a layer of an alloy of metals, and thus contains much less oxygen than a metal oxide which may be used as a dielectric. The applicants have found that the at least one intermediate layer may be sputtered in the same sputtering chamber in which the metal layer is sputtered. Preferably the applicants are sputtering both a seed and a blocker layer, and they are sputtering these two layers in the same chamber where the metal layer is sputtered.

In an embodiment of the present invention, the method is performed in continuous mode whereby a flexible substrate is passed through the process starting from a feed unwinding chamber and ending in a product winding chamber and is in between those chambers passed through a series of sputtering chambers in which the layers of the dichroic filter are subsequently deposited on the substrate. The applicants have found that this arrangement is highly convenient for obtaining as the product a composite in which the dichroic filter corresponds as closely as possible with the desired structure and that this structure is well and equally distributed over the entire surface of the substrate.

In an embodiment of the present invention wherein the method is performed in continuous mode, wherein the substrate is moving from a sputtering chamber wherein the at least one dielectric is sputtered and an adjacent chamber in which a metal is sputtered, and/or in the opposite sequence, the substrate is passing through a transit chamber between the two adjacent chambers having openings for the substrate. This brings the advantage that the compositions of the atmospheres in the two adjacent chambers may be controlled more independently from each other. This offers the preferred option in which the transit chambers are provided with their own connection with the vacuum system, such that elements that are present and possibly even desired in the atmosphere in one of the adjacent chambers, such as oxygen and/or water in the sputtering chamber for the dielectric, have less chance for also showing up in the other chamber where they may represent an undesired contaminant. Preferably, with or without the transit chamber, and also with and without the vacuum connection thereof, also the openings through which the substrate is passing are made as small or as narrow as practically possible, such that any possible contamination by of gas flowing from one chamber towards the adjacent chamber may be minimized and be kept as low as possible. This brings the benefit that any cross-contamination between the atmospheres in the two adjacent chambers may be kept low.

In an embodiment of the present invention wherein a transit chamber is used, the transit chamber is provided with a connection for pulling vacuum inside the transit chamber. The applicants have found that this feature brings an extra hurdle for any possible cross-contamination between the atmospheres in the two adjacent chambers. The applicants have found that with this provision, any of such cross-contamination may substantially be avoided and even eliminated.

In an embodiment of the present invention, the metal layer contains at least one metal selected from the group consisting of silver (Ag), titanium (Ti), copper (Cu), gold (Au), platinum (Pt), palladium (Pd), aluminium (Al), nickel (Ni), chromium (Cr), molybdenum (Mo), vanadium (V) or stainless steel.

In an embodiment, the metal layer contains silver. Silver (Ag) is by far the preferred metal for use in the metal layer of the at least one dichroic stack as part of the composite produced according to the present invention, because silver is the metal that offers a very high level of free electrons as well as a low absorption (which is converted into heat) while the absorption is also not selective and hence does not give colour to the composite. Therefore, in an embodiment of the composite produced according to the present invention, silver is the major component in the metal layer, and possibly even the only component in the metal layer.

Silver is prone to corrosion and diffuses also rather readily, so that it quickly migrates. This leads to a clustering that may occur in the silver metal layer and a migration of silver into the surrounding dielectric layers, leading to deterioration and even disappearance of the performance of the filter stack over time. A layer of pure silver by itself thus has a low stability, a low durability and poor moisture and weather resistance. The deterioration of the performance of the silver layer may be countered by providing a thicker metal layer containing the silver, but this inevitably has a negative influence on the VLT performance of the composite.

In an embodiment, the metal layer contains at least one metal other than silver, with or without silver being present. Such other metal may for instance be gold, platinum, palladium, ruthenium or another precious or platinum group metal. The metal layer may contain besides or instead of silver also a non-precious metal, such as copper, titanium, aluminium, nickel, chromium, molybdenum, vanadium, iron, or combinations thereof such as various versions of stainless steel, but the applicants have found that it is preferred to have at least silver and/or one of the precious metals present in the metal layer. The metal layer may for instance contain 5-15%wt of gold, as explained in US 4,799,745, US 7,709,095 and US 5,510,173. The presence of at least one other metal may bring the advantage of a higher stability of any silver that may also be present in the metal layer, also called bringing the benefit of "less corrosion", because the other metal is able to impair the migration of silver atoms and hence reduces the deterioration over time of the performance of the composite because of migration of silver into the layer(s) and the clustering of silver metal as part of the metal layer itself.

In an embodiment of the present invention, the dichroic filter further comprises at least one intermediate layer located between the dielectric layer and the metal layer, preferably the filter comprising one intermediate layer on both sides of the metal layer. The applicants prefer this way for increasing the stability of the metal layer above other alternatives mentioned elsewhere in this document. The applicants have found that this option is more reliable than the alternatives that bring alloying metals into the metal layer. The applicants have further found that this option brings a wider range of possibilities for bringing the desired effect.

The first intermediate layer that is deposited before the depositing the metal layer may be called the "seed layer" or "nucleation layer", while the second intermediate layer, which is deposited on top of the metal layer, may be called the "blocker layer".

In order to be able to perform its function of dichroic filter, or interference filter, it is understood and essential that the layers performing this function are continuous layers. This thus must apply to the at least one metal layer and to the at least two layers of dielectric material that are part of the dichroic filter that is produced by the method according to the present invention. The dielectric layers usually have a physical thickness of at least 10 nm, often at least 20 nm, and more preferably at least about 30 nm.

To the contrary, such "seed" and "blocker" layers are typically very thin, i.e. significantly thinner than the dielectric layers and typically also thinner than the at least one metal layer, and discontinuous. The seed and blocker layers are rather having a so-called "nanodot" structure. The islands of material of the seed layer are apparently providing favoured anchoring points for the silver atoms of the metal containing layer that is deposited upon it. Together, the seed and blocker layer are impairing the agglomeration of the metal atoms in the metal layer and this keeps the metal layer well distributed over the underlying dielectric layer such that a small thickness and well spread metal containing layer is formed and remains that way over the longer term use of the composite.

EP 1588950 B1 proposes to apply an extra intermediate layer comprising gold or gold comprising 10%wt of silver, preferably on both sides of the higher purity silver containing layer, whereby the intermediate layers increase the stability of the silver containing metal layers and avoid the intermixing at the interface of the silver containing layer and the metal oxide (dielectric) layer.

In an embodiment of the present invention wherein the composite comprises at least one intermediate layer, the intermediate layer comprises at least one of the metals or alloys from the group consisting of gold, silver, palladium, platinum, palladium, ruthenium or another precious or platinum group metal, nickel, nickel alloyed with chromium, indium, gallium, antimony, arsenic, aluminium, antimony and/or arsenic together with indium and/or gallium, indium antimonide, gallium antimonide, indium gallium antimonide, indium arsenide, gallium arsenide, indium gallium arsenide and indium aluminium arsenide. The applicants have found that these options are highly suitable for providing an intermediate layer in between the metal layer and the dielectric such that the metal layer gains in stability. In between this group, the applicants prefer to use the combination of elements comprising indium, gallium, antimony or arsenic, because suitable forms of these elements and their alloys are readily available from a number of different sources.

The intermediate layers may thus comprise gold, palladium, platinum, palladium, ruthenium or another precious or platinum group metal, nickel, optionally nickel alloyed with chromium, in particular alloys thereof with silver, or other elements or alloys, such as the group of alloys disclosed in WO 2012/080951 A1 comprising indium (In), gallium (Ga), antimony (Sb) and arsenic (As), for instance antimony and/or arsenic together with indium and/or gallium, such as indium antimonide, gallium antimonide, indium arsenide, indium gallium arsenide, gallium aluminium arsenide and/or gallium arsenide. A major drawback of gold however is its high price.

In an embodiment of the present invention, the dielectric layer comprises at least one non-metallic material that is transparent to both visible and infrared radiation. These materials include inorganic oxides but other materials such as organic polymer may be included. Preferably the dielectric layer comprises materials having an index of refraction in the range of 1.4 to 2.7, preferably in the range of 1.75 to 2.25. Preferably the dielectric layer comprises at least one compound selected from metallic and semi-metallic oxides, for example lead oxide, bismuth oxide, zinc oxide, indium oxide, tin oxide, titanium dioxide, silicon oxide, silicon dioxide, bismuth oxide, chromium oxide, tungsten oxide, indium titanium oxide, indium tungsten tin oxide, copper(I) oxide, fluorine doped tin oxide (FTO), niobium oxide, lithium doped nickel oxide (L-NiO), barium tin oxide, zinc magnesium beryllium oxide, as well as other inorganic metal compounds and salts, such as zinc sulphide, aluminium fluoride and magnesium fluoride and mixtures thereof. Of these materials, preference is given to zinc oxide, indium oxide, tin oxide, and mixtures thereof, and titanium dioxide. Most preferred is titanium dioxide ($TiO_2$), preferably the dielectric layer is all titanium dioxide ($TiO_2$), or at least a form of $TiO_x$ that approaches the formula of titanium dioxide, as explained elsewhere in this document. Other suitable inorganic dielectrics are listed in sources such as Musikant, Optical Materials, Marcel Dekker, New York, 1985, pp. 17-96.

The applicants prefer by far to use inorganic oxides, preferably metal oxides, for the dielectrics as part of the interference filters for the composites produced according to the present invention, because of their high refractive index. A higher refractive index material needs a lower layer thickness for obtaining the same effect.

Layers of metal oxides may also be formed by sputtering. Sputtering is performed in a sputtering chamber in which typically a vacuum is installed of 0.1 Pa up to 10 Pa (typically a few millitorr (mTorr) up to 100 mTorr). A gas may be introduced into the sputtering chamber, often an inert gas such as argon. Oxygen gas may also be used, alone or in addition to an inert gas, for instance when the purpose is to deposit on the substrate a metal oxide such as $TiO_2$ from a target of titanium metal or from a target made of titanium oxide. The use of a reactive gas, e.g. oxygen, during sputtering, may be addressed as "reactive sputtering".

Preferred dielectric materials are metal oxides, particularly oxides of metals that readily reduce and become "sub-stoichiometric", i.e. oxides that readily form vacancies in the solid oxide structure. Examples of very suitable metal oxides are indium tin oxide (ITO) and titanium dioxide (TiO$_2$).

The material preferred by the inventors for forming the dielectric layer(s) in the dichroic stack is comprising titanium dioxide (TiO$_2$), preferably titanium dioxide being the major component in the dielectric layers. The high refractive index of titanium dioxide allows the layers thereof to be thinner than with other materials for obtaining the target effect and required performance. As explained above, such titanium dioxide layer is usually obtained by reactive sputtering of a titanium oxide target, whereby usually oxygen gas is added to the sputtering gas to assure the deposited layer is sufficiently rich in oxygen.

In an embodiment of the present invention, the transparent support has a shear modulus at room temperature of at least 0.5 GPa and at most 80 GPa, meaning the support is qualified as being "rigid".

The applicants have found that in an embodiment of the method according to the present invention, the transparent support may be a rigid material characterised by the material having a shear modulus at room temperature of at least 0.5 GPa, preferably at least 0.6 GPa, more preferably at least 0.70, 0.75, 0.80, 0.85, 0.90, 0.95, 1.00, 1.1, 1.2, 1.3, 1.4 or 1.5 MPa. Using a rigid material for the transparent support brings the advantage that the composite itself may bring mechanical strength and that therefore the composite itself may be used as a construction element. There is thus no need to provide an extra mechanical support for supporting the dichroic filter, which is advantageous because all suitable transparent materials do bring their own effects on the transmittance spectrum of the assembly with the composite produced according to the present invention. This embodiment thus brings the advantage that the transmittance spectrum of the composite allows to also fairly correctly predict or derive the spectrum of the radiation that is expected to pass through the ultimate construction element that is intended to contain the composite.

The applicants have found that many materials are suitable as a rigid transparent support. Preferably the transparent support is comprising a material selected from glass, suitable forms of polyester, including polyethylene terephthalate (PET) and polyethylene naphthalene (PEN), polycarbonate (PC), polymethyl methacrylate (PMMA), polyethyl methacrylate (PEMA), and other acrylic plastics, polyvinyl chloride (PVC), polystyrene (PS), polyethylene (PE), polyvinylidene fluoride (PVDF), ethylene tetrafluoroethylene (ETFE), ethylene chlorotrifluoroethylene (ECTFE), polyphenyl ether (PPE), polyamide, such as nylon 11 or polyamide 11 (PA11), combinations and copolymers of some of these polymers such as PET/PMMA, PET/coPMMA, PVDF/PMMA, PVDF/coPMMA, PEN/PMMA, PEN/coPMMA, PEN/coPE, PEN/sPS, PEN/coPET and PEN/PETG, whereby PETG refers to polyethylene terephthalate glycol-modified. Preferably the glass is selected from float glass and curved glass, preferably the transparent support being one layer of laminated glass.

The applicants have found that the composite produced according to the present invention and having a rigid support may bring its target beneficial technical effects into practice in many applications. One of those highly suitable applications is as an element in so-called "laminated glass", in which the term "glass" should be understood much broader because it may include other suitable polymers such as polycarbonate, PMMA or another acrylic plastic.

In an embodiment of the present invention wherein the transparent support is one glass layer of laminated glass, the method further comprising the assembly of the laminated glass. This assembly may comprise a sequence of steps. In one embodiment, the assembly may comprise the application of the precursor composition of the intermediate plastic or polymer adhesive layer of the laminated glass onto the interference filter. Alternatively the assembly may comprise the steps of applying the dichroic filter onto the layer of precursor composition or on the adhesive layer that has already been formed on a glass layer, positioning a second glass layer of the laminated glass onto the intermediate plastic layer, on the dichroic filter or on a second intermediate layer of either precursor composition or on an adhesive layer that was coated on top of the dichroic filter. The assembly may then further comprise the step of bonding the layers together by cross-linking the intermediate plastic layer under pressure and/or temperature, preferably the intermediate plastic layer comprising polyvinyl butyral (PVB), ethylene-vinyl acetate (EVA), at least one ionoplast polymer, cast in place (CIP) liquid resin, or thermoplastic polyurethane (TPU), more preferably the intermediate plastic layer being an elastic material such as EVA, TPU or "acoustic PVB".

The uses of laminated glass are plenty, and the composite produced according to the present invention may bring benefits in almost all of them.

In an embodiment of the present invention wherein a laminated glass is produced, the laminated glass is used in a glass sculpture, a photovoltaic panel, a UV protecting panel, or in the construction of a building, a greenhouse, an animal shelter or stable, or of a vehicle, preferably as a window in an architectural application, a vehicle, preferably as a safety glass, a windscreen, as another window, as bulletproof glass or penetration-proof glass, and this in a wagon, a bicycle, a motor vehicle such as a motorcycle, a car, a truck, a bus, a railed vehicle such as a train or a tram, a watercraft such as a ship a boat or an underwater vehicle, an amphibious vehicle such as a screw-propelled vehicle or a hovercraft, an aircraft such as an airplane, a helicopter or an aerostat, or in a spacecraft, in a staircase, in a rooftop, in a floor, a canopy or a beam.

In an embodiment of the present invention, the transparent support has a shear modulus at room temperature of a flexible material, meaning that the shear modulus is in the range of at most 0.5 GPa and at least 0.1 MPa.

Preferably the shear modulus of the flexible support is at most 0.2 GPa, preferably at most 0.1 MPa, more preferably at most 750, 600, 500, 400, 250, 100, 75, 50, 25, 10, 5.0, 1.0, 0.5 or 0.15 MPa.

Preferably the transparent support comprising a flexible material selected from a polymer, preferably a polymer selected from polycarbonate, poly(meth)acrylate, another acrylate polymer, and polyester, such as polyethylene terephthalate (PET), polymethyl methacrylate (PMMA), cellulose triacetate (TCA or TAC), and polyurethane (PU), further possibilities being suitable forms of polyester, including polyethylene terephthalate (PET) and polyethylene naphthalene (PEN), polycarbonate (PC), polymethyl methacrylate (PMMA), polyethyl methacrylate (PEMA), and other acrylic plastics, polyvinyl chloride (PVC), polystyrene (PS), polyethylene (PE), polyvinylidene fluoride (PVDF), ethylene tetrafluoroethylene (ETFE), ethylene chlorotrifluoroethylene (ECTFE), polyphenyl ether (PPE), polyamide, such as nylon 11 or polyamide 11 (PA11), combinations and copolymers of some of these polymers such as PET/PMMA, PET/coPMMA, PVDF/PMMA, PVDF/coPMMA, PEN/PMMA, PEN/coPMMA, PEN/coPE, PEN/sPS, PEN/coPET and PEN/PETG, whereby PETG refers to polyethylene terephthalate glycol-modified.

In an embodiment of the present invention the transparent support is a film having a thickness in the range of at least 5 and at most 50 micrometre ($\mu$m), preferably at least 10, 15, 20 or 25 $\mu$m and optionally at most 45, 40, 35, 30, 25, or 20 $\mu$m.

The applicants have found that the composite based on a flexible support may form an excellent start for producing a product that is highly suitable in particular applications.

In an embodiment of the present invention, the dichroic filter is coated on a temporary support, which may be rigid, e.g. one of the suitable rigid materials listed elsewhere in this document, but preferably is flexible, e.g. one of the suitable flexible materials listed elsewhere in this document, and which has first been coated with a first adhesive layer. This first adhesive layer may e.g. be applied by a conventional coating technique, such as described elsewhere in this document, and the temporary support carrying the first adhesive layer may then be subjected to the sputter-deposition treatment as specified as part of the method according to the present invention for applying the layers of the dichroic filter. Alternatively the first adhesive layer may be applied by an extra sputtering step, possibly performed upstream of the sputtering-deposition applying the layers of the dichroic filter. The dichroic filter is thus applied after, and preferably atop the first adhesive layer. The adhesive layer should be transparent, hence the process of applying the dichroic filter is still complying with the prescriptions of the method according to the present invention.

This intermediate film may be convenient for storing and transporting the dichroic filter to where it is brought into its final position. Later, before bringing the dichroic filter into its ultimate position, a second adhesive layer may be applied onto the side of the dichroic filter opposite the side with the first adhesive layer. This second adhesive layer may be applied using any conventional coating technique, such as evaporation or chemical vapour deposition (CVD), but may also be applied using sputtering. Before or after applying this second adhesive layer, the temporary support may be removed and the dichroic filter, sandwiched between the two adhesive layers, may then be glued in between two transparent supports. In the case of laminated glass, at least one and preferably both of these two transparent supports is glass or a suitable alternative listed elsewhere in this document. It is quite common that the assembly comprises a suitable treatment step to make the two adhesive layers stick to the transparent supports, typically by causing cross-linking in and/or of the adhesive layers. This may be performed by exposure to pressure and/or temperature, or by the treatment by means of an E-beam crosslinking apparatus.

In this embodiment of the process, the temporary support may but must not necessarily be transparent. The composite of the method according to the present invention is thus obtained in all the embodiments. When the temporary support is non-transparent, this composite is certainly and possibly again obtained after the temporary support has been removed. The temporary support thus acts as a temporary carrier layer that is not functional in the end-use application, but is only needed for allowing the application of the layers of the dichroic filter specified as part of the composite that is the ultimate product of the method according to the present invention.

In an embodiment of the present invention wherein the transparent support has a shear modulus at room temperature of a flexible material, the method further comprises the step of providing an adhesive layer on at least one side of the transparent support, preferably on the side that has been coated with the dichroic filter, preferably the adhesive layer being provided by lamination, preferably the adhesive layer comprising a dry adhesive, more preferably a dry adhesive selected from a clear dry adhesive (CDA) and a pressure sensitive adhesive (PSA), preferably an adhesive derived from acrylic acid and/or methacrylic acid, preferably the adhesive layer having a thickness in the range of 0.5 to 5 $\mu$m, typically 1.5 $\mu$m, whereby on top of the adhesive layer is preferably also provided a release liner for providing protection until the composite is going to be glued to another substrate, preferably the release liner being a PET film having a thickness of about 25 $\mu$m. In many applications, it may be advantageous to glue the composite produced according to the present invention to another support, usually a more rigid support in order to give the composite structural support and the assembly with the other support becoming suitable as a construction element. This embodiment brings the advantage that the composite contains only one layer of transparent support, typically thus only the one layer on which the dichroic filter has been deposited, and therefore exhibits a very low absorbance in the long-infrared wavelength range compared to composites containing two layers of the support type, in many cases both being PET films. This brings the advantage that the composite produced according to the present invention may be characterised by a low emissivity ("low-E"). Such a low-E property of the composite is important when the composite is protecting an enclosure or inside space from heat input from the outside. This is because there is less material available for absorbing radiation energy, in particular on the side of the dichroic filter that is facing the outside of the enclosure. This results in a lower heating up of the construction element of which the composite has become a part, which means that the construction element will thus emit less radiation in the L-IR wavelength range, and thus less heat, to its surroundings, importantly also towards the inside of the enclosure.

In an embodiment of the present invention wherein the transparent support has a shear modulus at room temperature of a flexible material, the method further comprises the step of applying directly on the dichroic filter (DF) a protecting film consisting of another flexible film, an acrylate wet coating or a wet coating applied by a method comprising the application of a sol-gel technique, preferably the method and sol-gel technique that are described in WO 2017/097779 A1 for producing a product having low emissivity properties, or by laminating on the interference filter another flexible film. Such a film is preferably comprising a flexible material selected from a polymer, preferably a polymer selected from polycarbonate, poly(meth)acrylate and polyester, such as polyethylene terephthalate (PET), polymethyl methacrylate (PMMA), cellulose triacetate (TCA or TAC), and polyurethane (PU), preferably the other flexible film being a film having a thickness in the range of 5 to 50 micrometre ($\mu$m), typically 25 $\mu$m.

The protecting film brings the advantage of providing protection to the materials used in the composite, in particular of the metals, alloys and dielectric materials that compose the different layers of the dichroic filter or filters. This brings the advantage that the filter is more stable and is able to provide its shielding properties over a longer period of time.

The protecting film may be provided by means of the sol-gel technique, and this brings the further advantage that the film applied by that technique may be made to exhibit a very low absorbance in the long-infrared wavelength range, which may bring the advantage that the composite produced according to the present invention may also be characterised by a low emissivity ("low-E").

In an embodiment of the present invention wherein the transparent support has a shear modulus at room temperature typical of a flexible material, the method further comprises the step of providing a hardcoat layer on one side of the transparent support. The hardcoat layer brings extra physical protection to the composite, such as scratch resistance. The hardcoat typically has a lower thickness as compared to the films that are used as transparent support of the composite, or as protecting film for the dichroic filter. The hardcoat may also be made of low absorbance material, e.g. material that is highly transparent for mid-to-long-infrared radiation in the range of 5000 to 25000 nm.

In one embodiment, the hardcoat layer may be provided on the side of the support that is carrying the dichroic filter, also known as the coated side of the transparent support. This brings the advantage that the hardcoat layer brings the extra physical protection on the side where the dichroic filter is residing, and this without the drawbacks brought by an extra protecting film in between the dichroic filter and the hardcoat. These embodiments may for instance be more suitable for use in the inside of an isolating glass unit (IGU), where there is less risk for deterioration because of wear.

In another embodiment, the hardcoat layer is provided on the side opposite of the side that has been coated with the dichroic filter. This may be convenient if the composite is intended for sticking it by means of an adhesive layer directly with the side carrying the dichroic filter onto a transparent support, such as a glass plane, e.g. the inside surface of a single glass window, or of an insulating glass unit, of which one desires to improve the transmission characteristics. This embodiment brings the benefit that the overall solution counts one less PET layer. There is therefore less material present on the side of the dichroic filter that is exposed to the sunlight, such that less of the energy may be absorbed and converted into heat, such that less heat is dissipating and/or radiated out again. Such composites may thus also qualifty as "low-E" films or foils.

Preferably the hardcoat layer is applied by lamination, preferably the hardcoat comprising an acrylate wet coating or a wet coating applied by a method comprising the application of a sol-gel technique, preferably the method and sol-gel technique that are described in WO 2017/097779 A1 for producing a product having low emissivity properties.

The applicants prefer to provide this hardcoat because of the scratch resistance properties that it provides. The applicants have found that scratches or defects that are caused during the transport, the handling and the fixing of the composite are able to reduce the aesthetic appeal and also the technical performances of the product that is comprising the composite as produced according to the present invention in its target position. The hardcoat brings the advantage that the risk for scratches of other similar defects is minimized.

The hardcoat layer may also be applied when the support is qualified as being "rigid".

The applicants have found that the composite produced according to the present invention and having a flexible support may bring its target beneficial technical effects into practice in many applications. The possible uses are plenty, and the composite produced according to the present invention may bring benefits in almost all of them.

In an embodiment of the present invention wherein the transparent support has a shear modulus at room temperature typical of a flexible material, the method further comprises the step of incorporating the composite as a construction element into a structure such as a building, a vehicle, a glass sculpture, a photovoltaic panel, a UV protecting panel, or in the construction of a building, a greenhouse, a polytunnel, an animal shelter or stable, or of a vehicle.

The applicants have found that the composite produced in accordance with the present invention in which the transparent support has a shear modulus at room temperature typical of a flexible material, may be used, employed or put into commercial use, in a variety of different forms.

In an embodiment of the present invention comprising the fixing the composite as a construction element of a structure, the composite is used in at least one of the following forms:

- With two adhesive layers, one on the side of the dichroic filter and one on the opposite side, sandwiched in between two transparent plates, thereby forming an assembly,
- With one adhesive layer glued to one side of a transparent plate such as a glass plate, thereby forming an assembly, by means of the adhesive layer that is provided directly on the dichroic filter or alternatively on the opposite side of the composite, preferably the composite glued to surface 2 of insulating glass,
- With a protective film stretched in between surfaces 2 and 3 of insulating glass, thereby forming an assembly,
- With a protective film sandwiched between two layers of intermediate plastic that are sandwiched between the two rigid transparent plates, together forming an assembly.

In the art of insulating glass units ("IGU"), it is industry practice to number the surfaces starting with giving the exterior surface of the glass unit the number 1 (one), and sequentially increasing the number for the subsequent surfaces that are encountered when one is counting towards the interior surface of the glass unit.

In an embodiment of the present invention comprising the incorporating the composite as a construction element into a structure, the method further comprises the step of incorporating the assembly into a building, a vehicle, a glass sculpture, a photovoltaic panel, a UV protecting panel, or as an element in the construction of a building, a greenhouse, an animal shelter or stable, or of a vehicle, preferably as a window in an architectural application, a vehicle, a window, a windscreen, for instance as part of an insulating glass unit (IGU), safety glass, bulletproof glass or penetration-proof glass, and this in a wagon, a bicycle, a motor vehicle such as a motorcycle, a car, a truck, a bus, a railed vehicle such as a train or a tram, a watercraft such as a ship a boat or an underwater vehicle, an amphibious vehicle such as a screw-propelled vehicle or a hovercraft, an aircraft such as an airplane, a helicopter or an aerostat, or in a spacecraft, in a staircase, in a rooftop, in a floor, a canopy or a beam.

Although the transmission characteristics of a perfect dichroic filter may possibly be predicted by theory and by calculations, the applicants submit that this does not apply to industrially produced dichroic filters. In practice and in particular with sputter deposition, it remains impossible to predict the exact transmission performances of the dichroic filter that is produced. It takes a high level of experience in the art, combined with further trial and error, especially with respect to the various apparatus settings such as pressures, flows, power settings and processing speeds, to obtain a dichroic filter that is exhibiting or at least approaching the transmission performances that are desired.

As already alluded to earlier in this document, e.g. in the Summary of the Invention, the applicants have found that the method according to the present invention is an enabler for producing composites that offer superior transmittance characteristics, as compared to the same method that is not using any water at all during the sputtering of the at least one dielectric layer, or not using water as it is prescribed as part of the present invention. The applicants submit that the present invention further broadens the already wide range of capabilities of a particular sputter deposition apparatus because it offers extra methods that open product possibilities that were not existing or much more difficult to obtain without it. The applicants have found that the method according to the present invention therefore brings the capability to produce composites showing a combination of transmission characteristics that are very difficult to obtain otherwise. The applicants submit that these extra capabilities become possible thanks to the effect that is offered by the method according to the present invention, i.e. the capability to shift the transmittance spectrum to the left, i.e. towards lower wavelength ranges. The present invention thus offers an extra parameter for the sputtering operation, and also this parameter may be varied within a wide range meaning that its level of contribution to the transmission characteristics may also be controlled.

The applicants have further found that the method according to the present invention is particularly suitable for producing composites showing combinations of transmission characteristics that are highly desirable, and which composites may turn out to be highly suitable for use in particular end-use applications.

Because of the complexity of the sputtering process, the wide range of options available for the choice of metals and alloys for the metal layer, including silver but also e.g. copper and aluminium, the wide range of choices for the metals, alloys and compounds in the so-called seed and/or blocker layer, and the wide selection if dielectric materials, all having been discussed elsewhere in this document, and the limited predictability of the transmission characteristics obtained, it remains impossible to prescribe the set of materials, operating conditions, or the ranges of the operating parameters, that inevitably would lead to the desired combination of transmission characteristics. The applicants have found however that the composites as described further in this document are obtainable thanks to the availability of the present invention, and that this capability is illustrated by the examples.

In an embodiment, the composite produced according to the present invention exhibits the following transmittance characteristics established in accordance with Industry Standard NEN-EN 410,

(a) if the substrate carries only one single layer sequence that is able to represent a dichroic filter:

- a visible light transmittance ("VLT"), weighted as for the illuminant D65 reference, of at least 40%, and/or
- a transmittance in the wavelength range from 900 to 1000 nm ("T_IR"), weighted for the global solar radiation and the weighing factors normalised over the specified wavelength range, that is less than the VLT, preferably the T_IR being at most 80%, typically 66%,

and
(b) if the substrate carries at least two sequences that are able each to represent a dichroic filter:

- a visible light transmittance ("VLT"), weighted as for the illuminant D65 reference, of at least 50%, typically 71%, and/or
- a transmittance in the wavelength range from 900 to 1000 nm ("T_IR"), weighted for the global solar radiation and the weighing factors normalised over the specified wavelength range, that is less than the VLT, preferably the T_IR being at most 70%, typically 26%.

In an embodiment wherein the composite produced according to the present invention carries only one single dichroic filter, the visible light transmittance (VLT, weighted as for the illuminant D65 reference) of the composite is at least 42%, preferably at least 44%, more preferably at least 46%, even more preferably at least 48%, yet more preferably at least 50%, preferably at least 52%, more preferably at least 54%, even more preferably at least 56%, yet more preferably at least 58%, preferably at least 60%, more preferably at least 62%, even more preferably at least 64%, yet more preferably at least 66%, preferably at least 68%, more preferably at least 70%, even more preferably at least 72%, yet more preferably at least 74%, preferably at least 76%, more preferably at least 78%, even more preferably at least 80%, yet more preferably at least 82%, preferably at least 84%, more preferably at least 86%, even more preferably at least 88%, yet more preferably at least 90%. Optionally the VLT is at most 95%, preferably at most 94%, more preferably at most 93%, even more preferably at most 92%, yet more preferably at most 91%, preferably at most 90%, more preferably at most 89%, even more preferably at most 88%, yet more preferably at most 87%, preferably at most 86%, more preferably at most 85%, even more preferably at most 84%, yet more preferably at most 83%, preferably at most 82%, more preferably at most 81%, even more preferably at most 80%, yet more preferably at most 79%, preferably at most 78%, more preferably at most 77%, even more preferably at most 76%, yet more preferably at most 75%, preferably at most 74%, more preferably at most 73%, even more preferably at most 72%, yet more preferably at most 71%.

In an embodiment wherein the composite produced according to the present invention carries only one single dichroic filter, the transmittance in the wavelength range from 900 to 1000 nm (T_IR, weighted as for the global solar radiation and the weighing factors normalised over the specified wavelength range) of the composite is at most 79%, preferably at most 78%, more preferably at most 77%, even more preferably at most 76%, yet more preferably at most 75%, preferably at most 74%, more preferably at most 73%, even more preferably at most 72%, yet more preferably at most 71%, preferably at most 70%, more preferably at most 69%, even more preferably at most 68%, yet more preferably at most 67%, preferably at most 66%, more preferably at most 65%, even more preferably at most 64%, yet more preferably at most 63%, preferably at most 62%, more preferably at most 61%, even more preferably at most 60%, yet more preferably at most 59%. Optionally the T_IR of the composite carrying one single dichroic filter is at least 40%, preferably at least 45%, more preferably at least 47%, even more preferably at least 50%, yet more preferably at least 52%, preferably at least 55%, more preferably at least 57%, even more preferably at least 60%, yet more preferably at least 65%, preferably at least 70%.

In an embodiment wherein the composite carries at least two dichroic filters, the visible light transmittance (VLT, weighted as for the illuminant D65 reference) of the composite is at least 51%, preferably at least 52%, more preferably at least 53%, even more preferably at least 54%, yet more preferably at least 55%, preferably at least 56%, more preferably at least 57%, even more preferably at least 58%, yet more preferably at least 59%, preferably at least 60%, more preferably at least 61%, even more preferably at least 62%, yet more preferably at least 63%, preferably at least 64%, more preferably at least 65%, even more preferably at least 66%, yet more preferably at least 67%, preferably at least 68%, more preferably at least 69%, even more preferably at least 70%, yet more preferably at least 71%, preferably at least 72%, more preferably at least 73%, even more preferably at least 74%, yet more preferably at least 75%, preferably at least 76%, more preferably at least 77%, even more preferably at least 78%, yet more preferably at least 79%. Optionally the VLT is at most 90%, preferably at most 89%, more preferably at most 88%, even more preferably at most 87%, yet more preferably at most 86%, preferably at most 85%, more preferably at most 84%, even more preferably at most 83%, yet more preferably at most 82%, preferably at most 81%, more preferably at most 80%, even more preferably at most 79%, yet more preferably at most 78%, preferably at most 77%, more preferably at most 76%, even more preferably at most 75%, yet more preferably at most 74%, preferably at most 73%, more preferably at most 72%, even more preferably at most 71%, yet more preferably at most 70%.

In an embodiment wherein the composite carries at least two dichroic filters, the transmittance in the wavelength range from 900 to 1000 nm (T_IR, weighted as for the global solar radiation and the weighing factors normalised over the specified wavelength range) of the composite is at most 69%, preferably at most 68%, more preferably at most 67%, even more preferably at most 65%, yet more preferably at most 63%, preferably at most 60%, more preferably at most 58%, even more preferably at most 55%, yet more preferably at most 53%, preferably at most 50%, more preferably at most 48%, even more preferably at most 45%, yet more preferably at most 42%, preferably at most 40%, more preferably at most 37%, even more preferably at most 35%, yet more preferably at most 32%, preferably at most 30%, more preferably at most 28%, even more preferably at most 25%, yet more preferably at most 20%. Optionally the T_IR of the composite is at least 15%, preferably at least 16%, more preferably at least 17%, even more preferably at least 18%, yet more preferably at least 19%, preferably at least 20%, more preferably at least 21%, even more preferably at least 22%, yet more preferably at least 23%, preferably at least 24%, more preferably at least 25%, even more preferably at least 26%, yet more preferably at least 27%.

In an embodiment according to the present invention, the composite produced in accordance with the present invention is exhibiting, established in accordance with Industry Standard NEN-EN 410 and using the weighting factors for the global solar radiation that have been normalized for only the specified wavelength range, a transmittance in the wavelength range from 300 to 380 nm ("T_UV"), weighted for the UV part of the global solar radiation and the weighting factors normalised over the specified wavelength range, of at most 50%, preferably at most 45%, 40%, 35%, 30%, 25%, 20%, 15%, 10% or at most 5%.

It has been explained hereinabove that a reduced transmittance in the UV wavelength range, in particular in the UV-B range, is important for many reasons.

Radiation in the range below UV-A is also relevant because it is certainly capable of harming the cell development severely or even killing cell structures in living creatures. Indeed, humans, animals and plants may be affected as a result of the direct absorption of UV-B by a range of important molecules, including proteins, nucleic acids, and auxins. Consequently, UV-B has the potential to cause significant damage. Although the radiation of the sun in the UV range represents only 5% of the total energy in the full spectrum, the photons in this wavelength range represent a much more concentrated form of energy, which gives this wavelength range extra importance.

A reduction of the exposure to UV radiation as a whole should therefore be beneficial, because UV radiation is normally blocking biological life activities and may bring worse effects such as promoting skin cancer.

The applicants use the parameter T_UV, in the wavelength range from 300 to 380 nm, as a suitable parameter for representing the transmittance of UV radiation as a whole.

The applicants have found that a reduction in the T_UV by the composite produced according to the present invention, due to the general shape of the transmittance curve of a dichroic filter, brings an even stronger reduction of the transmittance in the UVb wavelength range relative UVa, which is beneficial because the UVb range which is even more harmful than UVa radiation. In buildings, vehicles, shelters, stables, and glass greenhouses, the UVb radiation may already mostly be kept out because it is almost completely blocked by traditional float glass that is typically omnipresent in the windows of such enclosures, and in the roof and walls of the greenhouse. UVb may also be fairly well blocked by some polymer films, such as polyethylene terephthalate (PET), but not with others such as polyethylene (PE). In other enclosures that do not use glass but use those other non-UVb blocking polymers, this extra effect on UVb transmittance through the composite may be a very important extra benefit, because the composite may be the only significant hurdle for incoming UVb radiation, e.g. when plastic materials are used, such as with a polytunnel.

The applicants have found that the composite produced according to the present invention is capable of strongly reducing the exposure of humans, animals and plants to UV radiation, and that this does have a positive effect on the longer term comfort level of the living creatures underneath, such as on the leaf formation and the growth of biomass in the plants in particular, and on plant growth and development in general.

In an embodiment of the present invention, the T_UV is at least 2%, preferably at least 3%, 4%, 5%, 6%, 7%, 8%, 9% or 10%, more preferably at least 11%, 12%, 13%, 14% or 15%, even more preferably at least 16, 17, 18, 19, 20, 21, 22, 23, 24, 25, 26, 27, 28, 29 or at least 30%.

Part of the UV radiation, in particular this in the range of UV-A, is beneficial and even needed for the photosynthesis, and hence for plant growth and development. The applicants have therefore found that it is preferable to maintain some but limited transmittance in the UVa wavelength range from 315 to 380 nm. The general shape of the transmittance spectrum of a composite in the use according to the present invention means that the transmittance in the range of 380-400 nm is always higher and usually significantly higher than this in the UV-A ranges. The wavelength range of 380-400 nm is the start of the visible part of the spectrum and it is also where the absorption of energy by the chlorophyll pigment starts, and hence also the production of biomass from carbon dioxide. The applicants have found that complying with the lower limit for the T_UV parameter is by this effect in the wavelength range of 380-400 nm also beneficial for the development of biomass by plants.

A compliance with this lower limit for T_UV brings a further advantage for fruit-bearing crops that need pollination by insects. The light in this range is not noticed by the human eye, but will be captured for instance by bees. These bees may be necessary to assure the pollination of the flowers of the crops which need to develop into the useful products. Having some UVa radiation available will further enhance the comfort level of bees underneath the composite, such that these insects are more comfortable and active in the performance of their pollination task.

In an embodiment, the composite produced according to the present invention is exhibiting, established in accordance with Industry Standard NEN-EN 410 and using the weighting factors for the global solar radiation that have been normalized for only the specified wavelength range, if the substrate carries only one single dichroic filter a transmittance in the red wavelength range of 600 to 700 nm ("T_red") of at least 50%, preferably at least 52%, more preferably at least 54%, even more preferably at least 56%, yet more preferably at least 58%, preferably at least 60%, more preferably at least 62%, even more preferably at least 64%, yet more preferably at least 66%, preferably at least 68%, more preferably at least 70%, even more preferably at least 71%, yet more preferably at least 72%, preferably at least 73%, more preferably at least 74%, even more preferably at least 75%, yet more preferably at least 76%, preferably at least 77%, more preferably at least 78%, even more preferably at least 79%, yet more preferably at least 80%, and optionally at most 95%, preferably at most 94%, more preferably at most 93%, even more preferably at most 92%, yet more preferably at most 91%, preferably at most 90%, more preferably at most 89%, even more preferably at most 88%, yet more preferably at most 87%, preferably at most 86%, more preferably at most 85%, even more preferably at most 84%, yet more preferably at most 83%, preferably at most 82%, preferably at most 81%, more preferably at most 80%, even more preferably at most 79%, yet more preferably at most 78%, preferably at most 77%, preferably at most 76%, more preferably at most 75%, even more preferably at most 74%, yet more preferably at most 73%, and, if the substrate carries at least two sequences that are able each to represent a dichroic filter, a transmittance in the red wavelength range of 600 to 700 nm ("T_red") of at least 40%, preferably at least 42%, more preferably at least 44%, even more preferably at least 46%, yet more preferably at least 48%, preferably at least 50%, more preferably at least 52%, even more preferably at least 54%, yet more preferably at least 56%, preferably at least 58%, more preferably at least 60%, even more preferably at least 62%, yet more preferably at least 64%, preferably at least 66%, more preferably at least 68%, even more preferably at least 70%, yet more preferably at least 71%, preferably at least 72%, more preferably at least 73%, even more preferably at least 74%, yet more preferably at least 75%, preferably at least 76%, preferably at least 77%, and optionally at most 95%, preferably at most 94%, more preferably at most 93%, even more preferably at most 92%, yet more preferably at most 91%, preferably at most 90%, more preferably at most 89%, even more preferably at most 88%, yet more preferably at most 87%, preferably at most 86%, more preferably at most 85%, even more preferably at most 84%, yet more preferably at most 83%, preferably at most 82%, preferably at most 81%, more preferably at most 80%, even more preferably at most 79%, yet more preferably at most 78%, preferably at most 77%, preferably at most 76%, more preferably at most 75%, even more preferably at most 74%, yet more preferably at most 73%.

The applicants have found that the composite produced according to the present invention may bring a transmittance that is particularly high in the red region of the visible light range, as represented by the T_red defined herein above. The applicants submit that a high T_red in the context of the present invention also brings along a high transmittance in the far red region light range of 700-780 nm. The high transmittance in these wavelength ranges is particularly beneficial for the development of flowers by plants, and hence for the bloom of flowering plants. Because a bloom is for many crops an intermediate stage in the development of fruits or other forms of harvest, the composite produced according to the present invention is able to bring substantial advantages in agriculture, in particular for the growing of crops in greenhouses.

Preferably the transmittance spectrum shows a relatively constant and high transmittance throughout the red light region (600-780 nm). Preferably the shape of the transmittance spectrum is such that the transmittance in the far red region (700-780 nm, "T_Far Red") is also high, and more preferably reaches almost the same level as the transmittance in the adjacent red light region (600-700 nm). The applicants have found that this feature is particularly beneficial for crops and plants that have a blooming stage, and hence is highly desirable in the agriculture in greenhouses where such crops are grown. For a higher yield of plants that flower and produce fruit underneath the composite produced according to the present invention, the ratio of (T_Far_Red / T_Red) is preferably at most 1.0 and at least 0.10.

In an embodiment, the composite produced according to the present invention is exhibiting, established in accordance with Industry Standard NEN-EN 410 and using the weighting factors for the global solar radiation that have been normalized for only the specified wavelength range, if the substrate carries only one single layer sequence that is able to represent a dichroic filter a transmittance in the blue wavelength range of 400 to 460 nm ("T_blue") of at least 20%, preferably at least 25%, more preferably at least 30%, even more preferably at least 35%, yet more preferably at least 40%, preferably at least 45%, more preferably at least 50%, even more preferably at least 55%, yet more preferably at least 60%, preferably at least 65%, more preferably at least 70%, even more preferably at least 71%, yet more preferably at least 72%, preferably at least 73%, more preferably at least 74%, even more preferably at least 75%, yet more preferably at least 76%, preferably at least 77%, more preferably at least 78%, even more preferably at least 79%, yet more preferably at least 80%, and optionally at most 95%, preferably at most 94%, more preferably at most 93%, even more preferably at most 92%, yet more preferably at most 91%, preferably at most 90%, more preferably at most 89%, even more preferably at most 88%, yet more preferably at most 87%, preferably at most 86%, more preferably at most 85%, even more preferably at most 84%, yet more preferably at most 83%, preferably at most 82%, preferably at most 81%, more preferably at most 80%, even more preferably at most 79%, yet more preferably at most 78%, preferably at most 77%, preferably at most 76%, more preferably at most 75%, even more preferably at most 74%, yet more preferably at most 73%, and, if the substrate carries at least two layer sequences that are able each to represent a dichroic filter, a transmittance in the blue wavelength range of 400 to 460 nm ("T_blue") of at least 20%, preferably at least 25%, more preferably at least 30%, even more preferably at least 35%, yet more preferably at least 40%, preferably at least 45%, more preferably at least 50%, even more preferably at least 55%, yet more preferably at least 60%, preferably at least 65%, more preferably at least 70%, even more preferably at least 71%, yet more preferably at least 72%, preferably at least 73%, more preferably at least 74%, yet more preferably at least 75%, preferably at least 76%, preferably at least 77%, and optionally at most 85%, preferably at most 84%, more preferably at most 83%, even more preferably at most 82%, yet more preferably at most 81%, preferably at most 80%, more preferably at most 79%, even more preferably at most 78%, yet more preferably at most 77%, preferably at most 76%, more preferably at most 75%, even more preferably at most 74, yet more preferably at most 73%, preferably at most 72, preferably at most 71, more preferably at most 70%, even more preferably at most 69%, yet more preferably at most 68%, preferably at most 67%, preferably at most 66%, more preferably at most 65%, even more preferably at most 64%, yet more preferably at most 63%.

For enhancing this feature, the applicants prefer to incorporate at least one extra metal in the layers of the forming the dichroic filter. What follows are some suitable examples. Copper, alone or in combination with silver, may bring an increase of T_red relative to T_blue. It however may also bring a reduction of the VLT and an increase of the light absorption. Silver itself absorbs much less than other metals such as Cu and Al. Al may bring the opposite of Cu, by increasing T_blue relative to T_red, but all tend to reduce the VLT. NiCr in the seed and/or blocker layer may be added to increase the absorption over the full transmittance spectrum. It may be added to bring stability to Ag, bringing a better growth of the Ag layer.

The applicants have found that the composite produced according to the present invention is able to bring also a high transmittance in the blue wavelength range of 400 to 460 nm. A high T_blue parameter, in view of the typical general shape of the transmittance spectrum, usually brings along an even higher transmittance in the range 460-500 nm. Because the energy in the wavelength range 400-490 nm is particularly beneficial for the growth of biomass in leaves and stems of plants, the high T_blue that may be brought by the composite produced according to the present invention is a characteristic that is highly desirable in agriculture for plants of which the biomass in leaves and stems have commercial value, and the composite would be particularly convenient in the growth of such plants and crops in greenhouses and in polytunnels.

In an embodiment according to the present invention, the composite is exhibiting, established in accordance with Industry Standard NEN-EN 410 and using the weighting factors for the global solar radiation that have been normalized for only the associated wavelength ranges, a ratio of the transmittance in the deep blue wavelength range relative to the transmittance in the red wavelength range ("T_blue / T_red") of at least 20%, preferably at least 25%, more preferably at least 30%, even more preferably at least 40%, yet more preferably at least 50%, preferably at least 60%, more preferably at least 70%, even more preferably at least 75%, yet more preferably at least 80%, preferably at least 85%, more preferably at least 90%, even more preferably at least 95%, yet more preferably at least 100%, preferably at least 105%, and optionally at most 110%, preferably at most 105%, more preferably at most 100%, even more preferably at most 95%, and optionally at most 100%, preferably at most 95%, more preferably at most 90%, even more preferably at most 85%.

The applicants have learned from experiments that substantially all crop growth is able to benefit from exposure to the sunlight that is transmitted by the composite produced according to the present invention. The applicants therefore submit that the composite produced according to the present invention is highly suitable for being used in association with agriculture that is at least partially shielded, preferably agriculture in greenhouses.

Most importantly, the composite produced according to the present invention brings a high VLT and a low transmittance in the N-IR wavelength range, as characterised by the T_IR, both as specified in the main claims. This combination of the features of the composite produced according to the present invention is beneficial because it brings a high energy transmittance in the ranges important for crop growth, while it is limiting the energy transmittance in the N-IR range, the range that is considered responsible for most plant burns, i.e. the process whereby the leaves of a plant turn brown and dry out, and by excessive plant burn becomes lethal for the entire plant.

In a first extra possibility, the composite produced according to the present invention may bring a high transmittance of the red light, including the far red light, that is most beneficial for plant bloom, fruit setting and fruit ripening. In this possibility the composite is able to be of interest for the cultivation of flowers and fruit crops.

In a second extra possibility, the composite may bring a high transmittance in the blue light range, which is highly beneficial for photosynthesis and thus the increase of biomass. In this second extra possibility, the composite is able to bring the ratio of energy radiation in the blue light range relative to the red light range that is most appreciated by growing leafy and green vegetables.

Because of the low slope of the curve around the transition point from visible to IR wavelengths, introducing a change in the dichroic filter of the conventional composite that is lowering the curve in the IR range usually also simultaneously lowers the transmittance in the visible light range, in particular in the red light range, i.e. close to the transition point. This may in addition cause the dichroic filter to exhibit a reflection having a reddish colour. This effect is undesired in most of the applications of the dichroic filter, such as in windows for buildings or vehicles. Ultimately the change also risks to reduce the overall VLT performance of the filter, which is also undesired.

Also on the lower end of the visible light spectrum, if, like with the conventional composites already known in the art, the steep part of the transmittance spectrum is located entirely inside the visible light spectrum, e.g. at or close to 500 nm, the filter and hence the composite may show a reflection having a blue-to-purple colour. Also this effect is undesired in most of the applications of the dichroic filter.

In order to avoid this blue/purple colour effect, it is known that the steep climb of the transmittance spectrum at the low end of the visible light spectrum may be moved to the left by increasing the level of oxygen in the sputtering gas when the titanium dioxide layer is being built. This however also brings down the transmittance spectrum in the entire visible light region, which reduces the VLT of the stack.

The present invention brings the benefit that these disadvantages may be avoided by the present invention without bringing down the VLT of the composite.

Therefore, in an embodiment, the composite produced in accordance with the present invention is exhibiting, established in accordance with Industry Standard ISO 11664-4: 2008, Colorimetry - Part 4, in the CIE L\*a\*b\* colour space of which the full ranges for a and b are expressed from -100 to +100, a colour difference calculated using the formula "Sqrt of ($a$^2 + $b$^2)" or "Sqrt of ($a^2 + b^2$)" (wherein "sqrt" stands for "square root") and relative to the colour of the illuminant D65 reference of at most 15, preferably at most 14, more preferably at most 13, even more preferably at most 12, yet more preferably at most 11, preferably at most 10, more preferably at most 9, even more preferably at most 8, yet more preferably at most 7, preferably at most 6, more preferably at most 5.

The applicants have found that the composite produced according to the present invention is able to exhibit a narrow range of colour neutrality in terms of the visible light that is transmitted, as defined above. The applicants have found, with a suitable selection of the substrate, that this also brings a tightly limited colour neutrality in the reflected light as visible by the human eye. The applicants have found that this allows for the composite produced according to the present invention to substantially and preferably completely avoid the colour problems that may occur with conventional dichroic filters, on the one hand the problem of a reddish colour reflection and on the other hand the problem of an indigo-violet colour reflection.

The composite produced according to the present invention is able to bring a solar heat shield that is exhibiting a high VLT and a low IR reflection, while maintaining a tightly defined "colour neutral" status, meaning that it is having a low reflection and/or a high transmittance of the blue and/or the red light, including far red, such that it is avoided that the composite picks up a reddish and/or a blueish-purple reflection.

EXAMPLES

The examples are using a sputtering apparatus that is comprising five (5) vacuum chambers in series. Vacuum chamber 1 is the unwinding chamber and vacuum chamber 5 is the winding chamber, although these functions may in certain embodiments be switched as explained further below. The three intermediate vacuum chambers are sputtering chambers, chambers 2 and 4 for sputtering in each one a dielectric layer and the middle chamber 3 for sputtering at least a metal layer, and if appropriate also a seed layer and/or a blocking layer. Middle chamber 3 is subdivided into three subchambers numbered 3.1, 3.2 and 3.3. Subchambers 3.1 and 3.3 are provided for sputtering respectively a seed layer and a blocking layer, subchamber 3.2 is for sputtering a metal containing layer.

The flexible substrate is unwound from a roll placed in the unwinding chamber, passes successively through the three sputtering chambers, and is wound again into a roll in the winding chamber. The substrate is passing from one chamber to the next through a slit that is made as narrow as possible but sufficiently large for letting the substrate pass without creating any impediment or hinder to the movement of the substrate.

The apparatus is thus equipped for coating onto the substrate in one pass of the substrate one full sequence of layers necessary for forming a stack that may correspond to one complete single dichroic filter (1DF). The symmetrical arrangement, if the apparatus is also equipped for operating in the reverse direction, may allow for subsequently returning the substrate with its first 1DF again in the opposite direction through the same apparatus and coating on top of the first dichroic filter the extra layers that correspond to a second dichroic filter, and this preferably without having to open the apparatus. The two dichroic filters on top of each other, are forming again a dichroic filter, herein referred to by the term "2DF", a filter that is having properties that are different from the two dichroic filters that make up the total stack of layers. Alternatively for obtaining a 2DF product, after having coated a 1DF, the apparatus may be opened and the roll of foil with the 1DF on it may be physically moved from the winding chamber to the unwinding chamber. The apparatus may then be closed again and brought under the required deep vacuum, after which the second filter may be coated on top of the first one during a second pass that the product is making through the entire apparatus.

Each one of the 5 vacuum chambers is connected with the vacuum pumping system that is provided for pulling and maintaining the required vacuum throughout the entire apparatus. The middle chamber is provided with 5 turbo high vacuum pumps arranged in parallel, the other four main chambers with 4 of such vacuum pumps each, also in parallel. The outlet of these 21 pumps come together into one common manifold, in which during operation a vacuum pressure is maintained in the range from 0.01 to 0.1 mbar (i.e. 1 Pa to 10 Pa) by means of a vacuum pumping system comprising a sequence of first and upstream a roots vacuum pump followed in series downstream by a rotation vacuum pump which delivers into the atmosphere. Three of such vacuum pumping systems are provided in parallel, of which all three are used during start-up and only two are sufficient during normal operation.

The slits connecting chamber 3 with chambers 2 and 4 are both equipped with a transit chamber consisting of a widening of the slit. Each one of these transit chambers is preferably also connected via at least one dedicated connection with the vacuum system.

A controlled supply of inert gas may be provided individually to each one of vacuum chambers 2 and 4, and to subchambers 3.1, 3.2 and 3.3, by means of mass flow meters. Vacuum chambers 2 and 4 are further provided with a controllable supply of oxygen gas, also via mass flow meters. Vacuum chambers 2 and 4 are also equipped with a controlled supply of water vapour, each time by being connected to two side chambers for containing an amount of liquid water below an amount of water-containing vapour phase, in each connection the flow of water vapour being controllable by means of a dedicated control valve. For this purpose, each connection was provided by a precision dosing valve type EVN 116 from the company Pfeiffer Vacuum. By means of the gas flow curve of the dosing valve and the pressure drop over the dosing valve, by means of setting the valve on a particular digital position indication, a precise flow of water vapour could be installed. These side chambers preferably have transparent walls and may be disconnected from the vacuum chamber upstream of the control valve, such that the liquid in the chamber may be replenished.

In the winding chamber 5, upstream of the winding roll, is provided a measurement device for measuring the transmittance spectrum of the coated PET film over the wavelength range of 320 to 1050 nm.

EXAMPLE 1 - 1DF composite

A roll of plastic foil with a width of 2 meters and a thickness of 50 $\mu$m was installed in vacuum chamber 1. The foil, in this document also called the plastic film, was made of polyethylene terephthalate (PET). The available end of the foil was brought from the unwinding roll through the entire apparatus, over every guiding roll and windlass and passing close to each one of the sputtering targets as well as the transmittance spectrum measurement device, and was finally attached to the winding roll in the winding chamber 5. The apparatus was closed and a vacuum of about $1 . 10^{-4}$ millibar (mbar), i.e. 0.01 Pa, was installed in vacuum chambers 2 and 4, while a vacuum of about $1 . 10^{-5}$ mbar (i.e. 0.001 Pa) was installed in vacuum chamber 3, including in all the three subchambers thereof. After having established these vacuum pressures in the different vacuum chambers, the following flows of argon were installed, expressed as standard cubic centimetres per minute (sccm):

| Vacuum Chamber | Inert gas flow (sccm) |
|---|---|
| 2 | 750 |
| 3.1 | 350 |
| 3.2 | 150 |
| 3.3 | 350 |
| 4 | 750 |

These numbers for the inert gas flows were calculated starting from the weight flow that can be read from the mass flow meters, converted first into a molar flow using the known molecular weight of the inert gas composition, and subsequently converting the molar flow into a standard volumetric flow using the known conversion factor from moles to gas volumes at the standard conditions of atmospheric pressure and 0°C.

Vacuum chambers 2 and 4 were each provided with a suboxide TiOx sputtering target in which "x" was in the range of 1.6 to 1.9. In vacuum chamber 3 were provided a sequence of 3 sputtering targets: target 2 made of silver, targets 1 and 3 were alloys made of 80%wt of nickel with 20%wt of chromium. During the conventional process, for obtaining the reference spectra against which is illustrated the present invention, towards each one of vacuum chambers 2 and 4 was installed a flow of oxygen. Before starting the working example according to the present invention, the flow of oxygen to vacuum chambers 2 and 4 was closed. Once the pressure has again stabilised, water addition was started, which resulted in an increase of the pressure in the particular vacuum chamber, which is believed to correspond to the rate of addition of water towards the chamber.

Before starting the production run, the apparatus is closed, and the vacuum systems are started up in the following sequence: the 3 rotating pumps are started first and able together to tighten all the seals and fully closing each one of the vacuum chambers. The roots pumps are commissioned subsequently until the pressure in the common manifold reaches its target. Then the turbo vacuum pumps are commissioned. Once the target deep vacuum is reached, the vacuum system is kept operating for another 9 hours before the production run is started.

The PET film movement was started from the unwinding roll to the winding roll, at a speed of 75 cm per minute. The sputtering targets were powered sequentially from sputtering chamber 2 over subchambers 3.1, 3.2 and 3.3 up to chamber 4. The magnetrons in the vacuum chambers were provided with the following powers, expressed in kilowatt (kW). The magnetrons in chambers 2 and 4 were AC magnetrons, the magnetrons in chamber 3 were all DC magnetrons.

| Vacuum Chamber | Power (kW) |
|---|---|
| 2 | 55 |
| 3.1 | 0.4 |
| 3.2 | 1 |
| 3.3 | 0.4 |
| 4 | 53 |

To vacuum chambers 2 and 4 was installed an oxygen flow of 18 standard cubic centimetres per minute (sccm). Having operated the apparatus in the mode as described during 3 hours, the transmittance spectrum 200923C51 of Figure 2 was registered. Subsequently the oxygen flow towards vacuum chambers 2 and 4 were raised to 24 sccm, and after 10 more minutes the transmittance spectrum 200923C59 of Figure 2 was registered. Spectra 200923C51 and 200923C59 are not according to the present invention.

After 10 minutes of operation following the registration of spectrum 200923C59, the oxygen flows towards the vacuum chambers 2 and 4 were discontinued. Under the continued admission of Ar, the pressure stabilised at a pressure of about $2.10^{-3}$ mbar. After pressure stabilisation the respective water vapour additions were opened towards the two vacuum chambers 2 and 4, by setting the precision dosing valves in the connections between the respective vacuum chamber and the associated side chamber at the position indication of 700, which should be corresponding with a constant flow of water vapour that was falling inside the range of 50-150 sccm. Relative to the 750 sccm of argon (Ar) that continued to be supplied to the respective vacuum chambers 2 and 4, the water vapour flows thus represented a ratio that was falling inside the range of from 6.6% up to 20%.

The installation of the water vapour flow was such that in each chamber a partial pressure of $3.10^{-4}$ mbar of water was established in both vacuum chambers 2 and 4 over the previously stabilised pressure in the respective vacuum chambers. After 15 more minutes of operation the transmittance spectrum 200923C85 of Figure 2 was registered.

The three transmittance spectra 200923C85 (with water, no oxygen) and 200923C51 and 200923C59 (both no water and with increasing oxygen addition rates) show that the water presence caused significant changes to the transmittance spectrum of the coated PET film (Spectrum 200923C85 relative to Spectrum 200923C51): transmittance in the NIR range (above 780 nm) was significantly reduced, transmittance in the visible range (range 380-780 nm) was even somewhat raised, in particular in the blue range (380-500 nm) and in the red range (620-780 nm), and transmittance in the UV range (below 380 nm) was still kept low. Comparison of spectrum 200923C59 with 200923C51 reveals that an increase of the oxygen addition has only a rather limited effect, clearly smaller than the changes that are brought by the water addition in the method according to the present invention.

For the three 1DF composites were calculated, based on the collected spectra, the %VLT using the weighing as specified in NEN-EN 410 for the illuminant D65 reference, and, this time using the weighing as specified in NEN-EN 410 for the global solar radiation and normalised for the specified wavelength range, the % transmittance in the range 400-460 nm (T_blue), in the range 600-700 nm (T_red), and in the range 900-1000 nm (T_IR). The results are shown in Table 1. Also the colour difference from the colour of the illuminant D65 was calculated in accordance with ISO 11664-4: 2008 in the CIE L*a*b colour space.

**Table 1 - 1 DF composite**

| % transmittance | 200923C51 (18 sccm $O_2$, no water) | 200923C59 (24 sccm $O_2$, no water) | 200923C85 (No $O_2$, with water) |
|---|---|---|---|
| VLT | 81 | 79 | 80 |
| T_IR | 70 | 71 | 66 |
| T_blue | 73 | 76 | 78 |
| T_red | 81 | 78 | 82 |

(continued)

| % transmittance | 200923C51 (18 sccm O$_2$, no water) | 200923C59 (24 sccm O$_2$, no water) | 200923C85 (No O$_2$, with water) |
|---|---|---|---|
| T_blue / T_red | 90 | 97 | 95 |
| Colour difference from D65 sqrt of (a$^2$+b$^2$) | 2.5 | 0.59 | 0.71 |

A comparison of the numerical results for spectrum 200923C51 with 200923C59 shows that the increase in the oxygen addition gave hardly any beneficial effect. A reducing effect in the near infrared region (T_IR) was hardly noticeable. An increase in the T_blue is clearly noticeable, but comes along with a decrease in the T_red transmittance, and also in the VLT. The drawbacks (reduced VLT and T_red) do therefore not appear to outweigh the benefit obtained in the blue wavelength range (T_blue). The increase of oxygen from 200923C51 to 200923C59 results in a higher colour neutrality as illustrated with the smaller colour difference. The addition of water, as compared with the addition of 18 sccm oxygen, i.e. when comparing the data for composites 200923C85 and 200923C59 individually with composite 200923C51, appears to deliver a comparable improvement of colour neutrality.

A comparison of the numbers for composites 200923C85 with 200923C51 shows that the VLT had remained almost the same, while the T-IR did significantly reduce. The present invention therefore demonstrates that it is able to reduce the transmittance in the near infrared region while maintaining a high VLT. The results also show that T_blue was significantly raised, and that also T_red was even slightly increased. The results also show that the colour difference with the D65 illuminant has also reduced, meaning that the colour neutrality of the composite was improved.

Figure 2 shows visually that the present invention is able to shift the transmittance spectrum to the left, i.e. towards the lower wavelengths. Without any significant reduction of the transmittance in the visible light spectrum (450-750 nm), the transmittance in the NIR range is substantially reduced. In addition, the transmittance of blue light is substantially increased, while the transmittance in the red light region is at least kept evenly high, even slightly increasing.

Figure 2 thus also shows that composite 200923C85 provides significant transmittance gains over the composites 200923C51 and 200923C59 in the transmittance in the range of 350-460 nm, which is particularly desired in greenhouse agriculture, e.g. when growing leafy and/or green vegetables. The improved transmittance represents a reduced reflection of the blue light, such that the composite gives a reflection that is less purple, which is desired in other applications such as buildings and vehicles. This improvement is also demonstrated by the improved colour neutrality in the above table.

EXAMPLE 2 - 2 DF composite

The same apparatus was used for producing a composite carrying a set of two dichroic filters. This composite was produced by passing the foil carrying the 1DF composite produced in Example 1 again through the same apparatus.

After the first production run, the intermediate film was rewound back onto the unwinding roll and the film was passed a second time through the same apparatus using slightly different conditions.

The purpose of the second pass is to eventually obtain a 2DF stack having the following composition: TiO$_2$ - Ni(80%)+Cr(20%) - Ag - Ni(80%)+Cr(20%) - TiO$_2$ - Ni(80%)+Cr(20%) - Ag - Ni(80%)+Cr(20%) - TiO$_2$.

For allowing the rewinding the roll, the apparatus was opened to the atmosphere, vented and opened. The 1DF roll from example 1 was fully rewound on a separate machine, and the rewound 1DF roll was reinstalled as the starting film in the unwinding chamber, i.e. vacuum chamber 1. The second production run commenced after reclosing the apparatus, the starting up and 9 hours of vacuum pumping.

During this second pass, the following powers were provided to the respective magnetrons in the corresponding vacuum chambers and subchambers:

| Vacuum Chamber | Power (kW) |
|---|---|
| 2 | 55 |
| 3.1 | 0.4 |
| 3.2 | 1.4 |
| 3.3 | 0.4 |
| 4 | 53 |

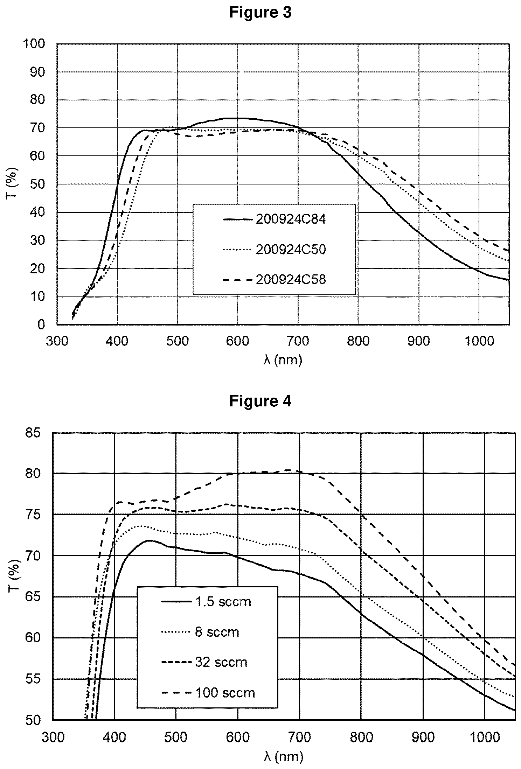

The same sequence of oxygen additions (two addition rates) and replacing the oxygen addition with the water addition were applied with the same timing as during the first production run, such that two metal interference filters were formed in which both dielectric-metal layers were deposited under similar conditions in the atmospheres in vacuum chambers 2 and 4. The production run of Example 2 thus resulted in 3 composites, products 200924C50 and 200924C58 with respectively 18 and 24 sccm oxygen addition to each vacuum chamber, and no water, and product 200924C84 with no oxygen addition but with water addition. For each of these three composites, the transmittance spectrum was measured and these spectra are shown in Figure 3.

For the composites were also calculated the %VLT using the weighing as specified in NEN-EN 410 for the illuminant D65 reference, and, this time using the weighing as specified in NEN-EN 410 for the global solar radiation and normalised for the specified wavelength range, the % transmittance in the range 400-460 nm (T_blue), in the range 600-700 nm (T_red), and in the range 900-1000 nm (T_IR). The results are shown in Table 2. Also the colour difference from the colour of the illuminant D65 was calculated in accordance with ISO 11664-4: 2008 in the CIE L*a*b colour space.

### Table 2 - 2DF composite

| % transmittance | 200924C50 (18 sccm O2, no water) | 200924C58 (24 sccm O2, no water) | 200924C84 (no O2, with water) |
|---|---|---|---|
| VLT | 69 | 68 | 71 |
| T_IR | 36 | 40 | 26 |
| T_blue | 48 | 55 | 63 |
| T_red | 69 | 69 | 73 |
| T_blue / T_red | 70 | 80 | 86 |
| Colour difference from D65 sqrt of (a2+b2) | 9.21 | 3.02 | 3.34 |

Most of the effects that were observed and discussed in relation to Table 1 and Figure 2 are showing again for the 2DF composite in Table 2 and in Figure 3, now in an amplified form.

The increase of the oxygen addition (Spectrum 200924C58 compared to 200924C50) was not able to further reduce the transmittance in the near infrared region (T_IR), but did cause a reduction in the VLT. T_blue did show some increase, and T_red remained the same. The colour neutrality did improve.

The effects brought by the water introduced in accordance with the present invention (Spectrum 200924C84 compared to 200924C50) were much more beneficial. The VLT now clearly increased while the T_IR reduced very significantly. Both the transmittance in the blue and the red range increased, and the colour became again significantly more neutral.

Figure 3 shows also more clearly the shift of the transmittance spectrum that is obtainable by the present invention to the left, hence towards lower wavelengths. Over practically the entire visible light range the transmittance has increased, while in the infrared, in particular in the N-IR, a significant reduction is accomplished in the transmitted energy. The gain in the blue light range does not show as spectacular in the graph, but is even more significant when comparing the transmittance for e.g. a wavelength of about 400 nm, where the present invention brings a relative gain from 24% to 46%, i.e. almost a doubling of the transmittance. Interesting to note also is that, in spite of this big increase in transmittance of blue light, the transmission in the range below 360 nm, i.e. the range of potentially harmful UV light, remained unchanged and low.

An entire roll of composite was produced under the same conditions as the composite with reference 200924C84 above. That composite was used in a greenhouse test for growing lettuce. The circumstances and further details of that test are explained as part of Example 6 in WO 2023/170215 A1.

The composite was fixed against the float glass roof of one greenhouse and the development of lettuce plants was monitored in that greenhouse and compared with those in a greenhouse without the optical filter and another greenhouse for which temporarily a white shading agent had been applied to its roof.

The tests demonstrated that the following results could be achieved:

- Temperature maintenance, both during hot days as well as during cold nights, was much better and easier as compared to the unprotected greenhouse. Much less ventilation and/or heating was required. In a greenhouse with air conditioning and/or heating ("HVAC") facilities, this is able to bring significant energy savings and also a carbon footprint reduction. Also water consumption is thereby reduced.
- Compared to the greenhouse with the shading agent, the plants fared much better, showing no stem stretching, and also any premature ageing and flowering was avoided. Using the composite produced according to the present invention may dispense with the need for a shading agent.

- In the unprotected greenhouse many plants showed high radiation damage, including necrosis and even completely dried leaves. None of this was observed in the greenhouse with the composite, where the plants thrived excellently and no stress conditions could be observed. The lettuce plants developed more leaves and more leave surface. In an industrial agricultural setting, this represents a major benefit in terms of much higher yield in valuable commercial product and much less waste and related burden.

The composite according to the present invention enabled these results without bringing any noticeable colouring of the transmitted light and/or the reflected light.

EXAMPLE 3 - 1DF composite with different levels of water present

Example 1 was repeated several times, with the following changes. The PET foil of which a roll was installed in vacuum chamber 1 had a thickness of only 23.4 $\mu$m. The available end of the foil was brought from the unwinding roll through the entire apparatus and finally attached to the winding roll in the winding chamber 5. The same sputtering targets as in Example 1 were installed in the same locations. After having established the same vacuum pressures as in Example 1, the same flows of argon were installed as in Example 1. The same start-up procedure as in Example 1 was used, and once the target deep vacuum had been reached, the vacuum system is also kept operating for another 12 hours before the production run was started.

The PET film movement was started from the unwinding roll to the winding roll, at a speed of 82.5 cm per minute. The sputtering targets were powered sequentially from sputtering chamber 2 over subchambers 3.1, 3.2 and 3.3 up to chamber 4. The magnetrons in the vacuum chambers were provided with the following powers, expressed in kilowatt (kW). The magnetrons in chambers 2 and 4 were AC magnetrons, the magnetrons in chamber 3 were all DC magnetrons.

| Vacuum Chamber | Power (kW) |
|---|---|
| 2 | 60 |
| 3.1 | 0.4 |
| 3.2 | 1 |
| 3.3 | 0.4 |
| 4 | 60 |

Under the continued admission of Ar, the pressure stabilised at a pressure of about $2 . 10^{-3}$ mbar. After pressure stabilisation the respective water vapour additions were opened towards the two vacuum chambers 2 and 4, by varying the precision dosing valves in the connections between the respective vacuum chamber and the associated side chamber from the position indication of 400 up to 900. By calibration measurements, this range of valve settings was known to correspond with a flow of water vapour in the range of from 1.5 up to 660 sccm. Relative to the 750 sccm of argon (Ar) that still continued to be supplied to each one of the respective vacuum chambers 2 and 4, the water vapour flows thus represented a ratio that was corresponding to the range of from 0.2% up to 88%.

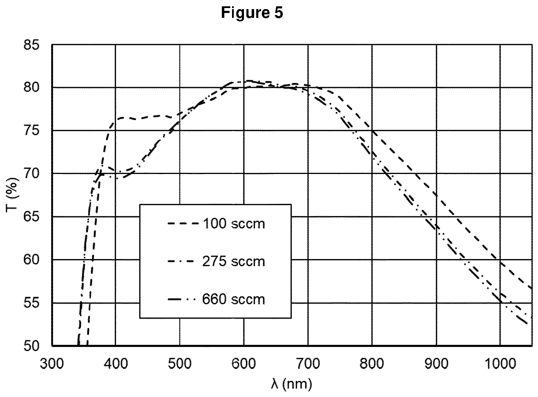

The installation of the water vapour flows was such that in each chamber a partial pressure from $5 . 10^{-5}$ mbar to $1 . 10^{-3}$ mbar of water was established in both vacuum chambers 2 and 4 over the previously stabilised pressure in the respective vacuum chambers. After 10 minutes of operation with a water vapour flow of 1.5 sccm, the corresponding transmittance spectrum of Figure 4 was registered. Subsequently the water vapour flow was raised to 8 sccm, and after 10 minutes of operation, the corresponding transmittance spectrum of Figure 4 was registered. In the same way, after intervals of 10 minutes and raising the water vapour flow to respectively 32 sccm, 100 sccm, 275 sccm and 660 sccm, the corresponding transmittance spectra of Figures 4 and 5 were registered.

For the six 1DF composites were calculated, based on the collected spectra, the %VLT using the weighing as specified in NEN-EN 410 for the illuminant D65 reference, and, this time using the weighing as specified in NEN-EN 410 for the global solar radiation and normalised for the specified wavelength range, the % transmittance in the range 400-460 nm (T_blue), in the range 600-700 nm (T_red), and in the range 900-1000 nm (T_IR). The results are shown in Table 3. Also the colour differences from the colour of the illuminant D65 was calculated in accordance with ISO 11664-4: 2008 in the CIE L*a*b colour space.

The six transmittance spectra ranging from 1.5 sccm (230221C36) to 660 sccm (230221C68), thus using increasing water levels and no oxygen, show in the drawings that the water presence caused significant changes to the transmittance spectrum of the coated PET film. This is also clearly shown by the numbers in Table 3. The transmittance in the NIR range (above 780 nm) significantly increases up to a water vapour flow of 100 sccm above of which it again decreases. The transmittance in the visible range (range 380-780 nm) was increasing up to a water vapour flow of 100 sccm (Figure 4) above of which it remained practically constant (Figure 5). In the blue range (380-500 nm), the transmittance increases up to a water vapour flow of 100 sccm, while in the red range (620-780 nm) the transmittance increases up to a water vapour flow of 100 sccm above of which it remains practically constant, and transmittance in the UV range (below 380 nm) increases with increasing the water vapour flow.

**Table 3 - 1 DF composite made with increasing water levels**

| Composite # Water flow | Wavelength (nm) | 230221C36 1.5 sccm | 230221C45 8 sccm | 230221C52 32 sccm | 230221C58 100 sccm | 230221C64 275 sccm | 230221C68 660 sccm |
|---|---|---|---|---|---|---|---|
| Water/Argon (%molar flow) | | 0.20% | 1.06% | 4.27% | 13.33% | 36.67% | 88.00% |
| VLT (%) | 380-780 | 71 | 73 | 76 | 78 | 78 | 78 |
| T_IR (%) | 900-1000 | 56 | 58 | 61 | 64 | 60 | 60 |
| T_blue (%) | 440-490 | 70 | 72 | 75 | 77 | 72 | 71 |
| T_red (%) | 620-700 | 69 | 72 | 76 | 80 | 80 | 80 |
| T_blue / T_red | | 102 | 101 | 99 | 95 | 89 | 89 |
| Colour difference from D65 sqrt of $(a^2+b^2)$ | | 0.84 | 0.35 | 0.34 | 1.95 | 5.10 | 5.29 |

A comparison of the series of numerical results starting from spectrum 230221C36 and up to spectrum 230221C68 shows that the increase in the water flow addition gave some beneficial effects up to a water vapour flow of about 100 sccm. An increasing effect in the near infrared region (T_IR), the VLT, T_blue and T_red is noted up to a water flow of 100 sccm. This possible drawback in some applications, i.e. an increased T_IR, is however compensated by an almost equivalent increase in the VLT. Above 100 sccm of water, the T_IR reduces again while the VLT remained very high. The major effect observed is the increase of the colour deviation from the D65 illuminant, which may be less desired in particular end-uses. The use of water vapour from 230221C36 up to 230221C58 (100 sccm) results in a good colour neutrality as illustrated with the very small colour difference with the D65 standard. Higher additions of water, as compared with the addition of 1.5 up to 100 sccm, appears to deliver a worse colour neutrality while maintaining a high VLT.

The different transmission spectra as obtained in this example are shown in Figures 4 and 5. Different from Figures 1-3, the ordinate scales in Figures 4 and 5 are now only showing the range of 50-85%.

In Figure 4 are shown the spectra for the water flows starting from 1.5 sccm up to 100 sccm (composites 230221C36 up to 230221C52). In Figure 5 are shown the spectra for the water flows of 100 sccm and higher (composites 230221C58 through 230221C68). The observations that are made above based on the numerical results are all clearly illustrated in Figure 4 and Figure 5.

Figure 4 shows that the 100 sccm composite (230221C58) provides significant gains over the composites (230221C36 up to 230221C52) that were made with less water, in the transmittance in the range of 600-700 nm (i.e. the red light range). This result may be particularly desired in greenhouse agriculture, e.g. for improving the rates of biomass growth, flowering and the setting and development of fruit. The increased transmittance in that same range also brings as associated effect a reduced reflection of the red light, such that the composite gives a reflection that is less red, an effect that may be desired in other applications such as buildings and vehicles. Table 3 also shows that the colour difference hardly changes and remains about unchanged, and hence fully neutral, for the composites in this range.

Figure 5 illustrates that, as the water flow is further increased above 100 sccm (up to 30% and above, expressed as a molar ratio relative to the inert gas flow), that the T_IR becomes reduced, but the transmission in the UV range (below 380 nm) is raised further. These two observations are again a reflection of the "shifting to the left" of the transmission spectrum, now by an increased presence of water, in this example as part of a no-oxygen comparison. While the VLT as a global parameter is maintained high at the higher water levels of 100 sccm or above, the spectra demonstrate, in spite of the further gain in the UV range, a significant drop of the transmission in the blue range (below 500 nm), which was already observed in the numbers for T_blue and its ratio to the T_red in Table 3, which is then compensated by further gains in the higher visible wavelengths of green-yellow light, an effect that appears to have disappeared and reversed when one moves further up into the far red light range (700-780 nm), where the transmission is actually reduced. This last effect may be desired in some applications, such as in agriculture, because of the possible harm that the far red light may bring. Figure 5 thus in a way also shows, as the amount of water is further increased above 30% relative to the inert gas flow, that the composite starts to develop a colour which may show up primarily in the reflected light, noticeable in some applications, but possibly also in the transmitted light, which may thus cause significant effects in other applications, such as in agriculture.

Having now fully described this invention, it will be appreciated by those skilled in the art that the invention can be performed within a wide range of parameters within what is claimed, without departing from the scope of the invention, as defined by the claims.

**Claims**

1. A method for the production of a visual light transmitting and infra-red reflecting composite including, adhered to one side of a transparent support, at least one dichroic filter (DF) which filter comprises at least one metal layer that is sandwiched in between two layers of dielectric metal oxide, dielectric inorganic compound or dielectric inorganic salt, wherein the layers of the dichroic filter are deposited sequentially onto the transparent support using sputter-deposition in at least one sputtering chamber, wherein the process comprises, in the sputtering chamber where at least one of the dielectric layers is sputtered, the introduction of at least one inert gas and water, **characterised in that** the molar flow of the water that is introduced into the sputtering chamber is in the range of 1% to 30% relative to the total molar flow of inert gas that is introduced into the same sputtering chamber.

2. The method according to claim 1 wherein, in the sputtering chamber in which the at least one of the dielectric layers is sputtered, the total pressure is controlled to be at most 0.005 mbar, preferably the atmosphere in the sputtering chamber comprising argon as the at least one inert gas.

3. The method according to claim 1 or 2 wherein, in the sputtering chamber in which the at least one of the dielectric layers is sputtered, the partial pressure of water is maintained in the range of at least 0.00001 mbar and 0.0015 mbar.

4. The method according to any one of the preceding claims wherein the water is introduced into the sputtering chamber as water vapour.

5. The method according to any one of the preceding claims that is performed in continuous mode whereby a flexible substrate is passed through the process starting from a feed unwinding chamber and ending in a product winding chamber and is in between those chambers passed through a series of sputtering chambers in which the layers of the dichroic filter are subsequently deposited on the substrate.

6. The method according to any one of the preceding claims wherein the metal layer contains at least one metal selected from the group consisting of silver (Ag), titanium (Ti), copper (Cu), gold (Au), platinum (Pt), palladium (Pd), aluminium (Al), nickel (Ni), chromium (Cr), molybdenum (Mo), vanadium (V) or stainless steel.

7. The method according to any one of the preceding claims wherein the dichroic filter further comprises at least one intermediate layer located between the dielectric layer and the metal layer, wherein the intermediate layer comprises at least one of the metals or alloys from the group consisting of gold, silver, palladium, platinum, palladium, ruthenium or another precious or platinum group metal, nickel, nickel alloyed with chromium, indium, gallium, antimony, arsenic, aluminium, antimony and/or arsenic together with indium and/or gallium, indium antimonide, gallium antimonide, indium gallium antimonide, indium arsenide, gallium arsenide, indium gallium arsenide and indium aluminium arsenide.

8. The method according to any one of the preceding claims wherein the dielectric layer comprises at least one non-metallic material that is transparent to both visible and infrared radiation.

9. The method according to the preceding claim wherein the transparent support is one glass layer of laminated glass, the method further comprising the assembly of the laminated glass.

10. The method according to the preceding claim wherein the laminated glass is used in a glass sculpture, a photovoltaic panel, a UV protecting panel, or in the construction of a building, a greenhouse, an animal shelter or stable, or of a vehicle, preferably as a window in an architectural application, a vehicle, preferably as a safety glass, a windscreen, as another window, as bulletproof glass or penetration-proof glass, and this in a wagon, a bicycle, a motor vehicle such as a motorcycle, a car, a truck, a bus, a railed vehicle such as a train or a tram, a watercraft such as a ship a boat or an underwater vehicle, an amphibious vehicle such as a screw-propelled vehicle or a hovercraft, an aircraft such as an airplane, a helicopter or an aerostat, or in a spacecraft, in a staircase, in a rooftop, in a floor, a canopy or a beam.

11. The method according to any one of claims 1-8 wherein the transparent support has a shear modulus at room temperature typical of a flexible material, meaning that the shear modulus is in the range of at most 0.5 GPa and at least 0.1 MPa.

12. The method according to the preceding claim further comprising the step of providing an adhesive layer on at least one side of the transparent support.

13. The method according to claim 8 further comprising the step of applying directly on the dichroic filter a protecting film consisting of another flexible film, an acrylate wet coating or a wet coating applied by a method comprising the application of a sol-gel technique.

14. The method according to any one of claims 11-13 further comprising the step of incorporating the composite as a construction element into a structure, wherein the composite is used in at least one of the following forms:

• With two adhesive layers, one on the side of the dichroic filter and one on the opposite side, sandwiched in between two transparent plates, thereby forming an assembly,
• With one adhesive layer glued to one side of a transparent plate such as a glass plate, thereby forming an assembly, by means of the adhesive layer that is provided directly on the dichroic filter or alternatively on the opposite side of the composite,
• With a protective film stretched in between surfaces 2 and 3 of insulating glass, whereby the surfaces of the insulating glass are numbered according to the standard practice with insulating glass units ("IGU") to number the surfaces starting with giving the exterior surface of the glass unit the number 1 (one), and sequentially increasing the number for the subsequent surfaces that are encountered when one is counting towards the interior surface of the glass unit, thereby forming an assembly,
• With a protective film sandwiched between two layers of intermediate plastic that are sandwiched between the two rigid transparent plates, together forming an assembly.

15. The method according to any one of the preceding claims wherein the composite exhibits the following transmittance characteristics established in accordance with Industry Standard NEN-EN 410,

(a) if the substrate carries only one single layer sequence that is able to represent a dichroic filter:

• a visible light transmittance ("VLT"), weighted as for the illuminant D65 reference, of at least 40%, and/or
• a transmittance in the wavelength range from 900 to 1000 nm ("T_IR"), weighted for the global solar radiation and the weighing factors normalised over the specified wavelength range, that is less than the VLT, preferably the T_IR being at most 80%,

and
(b) if the substrate carries at least two sequences that are able each to represent a dichroic filter:

• a visible light transmittance ("VLT"), weighted as for the illuminant D65 reference, of at least 50%, and/or
• a transmittance in the wavelength range from 900 to 1000 nm ("T_IR"), weighted for the global solar radiation and the weighing factors normalised over the specified wavelength range, that is less than the VLT, preferably the T_IR being at most 70%.

**Patentansprüche**

1. Ein Verfahren zur Herstellung eines sichtbares Licht durchlassenden und Infrarot reflektierenden Verbundstoffs, welcher, geklebt an eine Seite eines transparenten Trägers, mindestens einen dichroitischen Filter (DF) einschließt, wobei dieser Filter mindestens eine Metallschicht umfasst, die zwischen zwei Schichten von nichtleitendem Metalloxid, nichtleitender anorganischer Verbindung oder nichtleitendem anorganischem Salz eingebettet ist, wobei die Schichten des dichroitischen Filters unter Verwendung von Sputterdeposition in mindestens einer Sputterkammer sequenziell auf den transparenten Träger aufgebracht werden, wobei das Verfahren, in der Sputterkammer, wo mindestens eine der nichtleitenden Schichten gesputtert wird, die Einbringung von mindestens einem inerten Gas und Wasser umfasst,
**dadurch gekennzeichnet, dass** der Moldurchsatz des Wassers, das in die Sputterkammer eingebracht wird, im Bereich von 1 % bis 30 % in Bezug auf den Gesamtmoldurchsatz des inerten Gases liegt, das in dieselbe Sputterkammer eingebracht wird.

2. Das Verfahren nach Anspruch 1, wobei, in der Sputterkammer, in der die mindestens eine der nichtleitenden Schichten gesputtert wird, der Gesamtdruck kontrolliert wird, um höchstens 0,005 mbar zu betragen, wobei die Atmosphäre in der Sputterkammer bevorzugt Argon als das mindestens eine inerte Gas umfasst.

3. Das Verfahren nach Anspruch 1 oder 2, wobei, in der Sputterkammer, in der die mindestens eine der nichtleitenden Schichten gesputtert wird, der Partialdruck von Wasser im Bereich von mindestens 0,00001 mbar und 0,0015 mbar gehalten wird.

4. Das Verfahren nach irgendeinem der vorigen Ansprüche, wobei das Wasser als Wasserdampf in die Sputterkammer eingebracht wird.

5. Das Verfahren nach irgendeinem der vorigen Ansprüche, das kontinuierlich ausgeführt wird, wobei ein flexibles Substrat durch das Verfahren geführt wird, beginnend von einer Vorschubabwickelkammer und endend in einer Produktaufwickelkammer, und zwischen diesen Kammern durch eine Reihe von Sputterkammern geführt wird, in denen die Schichten des dichroitischen Filters nachfolgend auf das Substrat aufgebracht werden.

6. Das Verfahren nach irgendeinem der vorigen Ansprüche, wobei die Metallschicht mindestens ein Metall ausgewählt aus der Gruppe bestehend aus Silber (Ag), Titan (Ti), Kupfer (Cu), Gold (Au), Platin (Pt), Palladium (Pd), Aluminium (Al), Nickel (Ni), Chrom (Cr), Molybdän (Mo), Vanadium (V) oder Edelstahl enthält.

7. Das Verfahren nach irgendeinem der vorigen Ansprüche, wobei der dichroitische Filter ferner mindestens eine Zwischenschicht zwischen der nichtleitenden Schicht und der Metallschicht umfasst, wobei die Zwischenschicht mindestens eines der Metalle oder eine der Legierungen aus der Gruppe bestehend aus Gold, Silber, Palladium, Platin, Palladium, Ruthenium oder einem anderen Edel- oder Platinmetall, Nickel, Nickel legiert mit Chrom, Indium, Gallium, Antimon, Arsen, Aluminium, Antimon und/oder Arsen zusammen mit Indium und/oder Gallium, Indiumantimonid, Galliumantimonid, Indium-GalliumAntimonid, Indiumarsenid, Galliumarsenid, Indium-Gallium-Arsenid und Indium-Aluminium-Arsenid umfasst.

8. Das Verfahren nach irgendeinem der vorigen Ansprüche, wobei die nichtleitende Schicht mindestens ein nichtmetallisches Material umfasst, das sowohl für sichtbare als auch für Infrarotstrahlung transparent ist.

9. Das Verfahren nach dem vorigen Anspruch, wobei der transparente Träger eine Glasschicht aus Verbundglas ist, wobei das Verfahren ferner das Zusammenfügen des Verbundglases umfasst.

10. Das Verfahren nach dem vorigen Anspruch, wobei das Verbundglas in einer Glasskulptur, einer fotovoltaischen Platte, einer UVschützenden Platte, oder in der Konstruktion eines Gebäudes, eines Gewächshauses, eines Unterstands oder Stalles für Tiere, oder eines Fahrzeugs verwendet wird, bevorzugt als ein Fenster in einer architektonischen Anwendung, einem Fahrzeug, bevorzugt als ein Sicherheitsglas, eine Windschutzscheibe, als ein weiteres Fenster, als kugelsicheres Glas oder durchbruchsicheres Glas, und das in einem Waggon, einem Fahrrad, einem Motorfahrzeug wie einem Motorrad, einem Auto, einem Lkw, einem Autobus, einem Schienenfahrzeug wie einem Zug oder einer Straßenbahn, einem Wasserfahrzeug wie einem Schiff, einem Boot oder einem Unterwasserfahrzeug, einem Amphibienfahrzeug wie einem Fahrzeug mit Schraubenantrieb oder einem Luftkissenfahrzeug, einem Luftfahrzeug wie einem Flugzeug, einem Helikopter oder einem Aerostat, oder in einem Raumfahrzeug, in einer Treppe, in einem Dach, in einem Boden, einer Überdachung oder einem Balken.

11. Das Verfahren nach irgendeinem der Ansprüche 1 bis 8, wobei der transparente Träger ein Schermodul bei Raumtemperatur typisch für ein flexibles Material hat, was bedeutet, dass das Schermodul im Bereich von höchstens 0,5 GPa und mindestens 0,1 MPa liegt.

12. Das Verfahren nach dem vorigen Anspruch, welches ferner den Schritt des Bereitstellens einer Klebeschicht auf mindestens einer Seite des transparenten Trägers umfasst.

13. Das Verfahren nach Anspruch 8, welches ferner den Schritt des Auftragens einer Schutzfolie direkt auf den dichroitischen Filter umfasst, welche aus einer weiteren flexiblen Folie, einer Acryl-Nassbeschichtung oder einer Nassbeschichtung besteht, die durch ein Verfahren aufgebracht ist, das die Anwendung einer Sol-Gel-Technik umfasst.

**14.** Das Verfahren nach irgendeinem der Ansprüche 11 bis 13, welches ferner den Schritt des Eingliederns des Verbundstoffs als Konstruktionselement in eine Struktur umfasst, wobei der Verbundstoff in mindestens einer der folgenden Formen verwendet wird:

• Mit zwei Klebeschichten, eine auf der Seite des dichroitischen Filters und eine auf der gegenüberliegenden Seite, eingebettet zwischen zwei transparenten Platten, wodurch eine Anordnung gebildet wird,
• Mit einer Klebeschicht geklebt auf eine Seite einer transparenten Platte wie einer Glasplatte, dadurch eine Anordnung bildend, mittels der Klebeschicht, die direkt auf dem dichroitischen Filter oder alternativ dazu auf der gegenüberliegenden Seite des Verbundstoffs bereitgestellt ist,
• Mit einer Schutzfolie gespannt zwischen Oberflächen 2 und 3 von Isolierglas, wobei die Oberflächen des Isolierglases nach der Standardpraxis mit Isolierglaseinheiten ("IGU") nummeriert sind, um die Oberflächen zu nummerieren, beginnend mit der Vergabe der Nummer 1 (eins) an die äußere Oberfläche der Glaseinheit, wobei die Nummer für die nachfolgenden Oberflächen, die angetroffen werden, wenn man hin zur inneren Oberfläche der Glaseinheit zählt, wodurch eine Anordnung gebildet wird, sequenziell höher wird.
• Mit einer Schutzfolie eingebettet zwischen zwei Schichten von dazwischenliegendem Kunststoff, die zwischen den zwei starren transparenten Platten eingebettet sind, die zusammen eine Anordnung bilden.

**15.** Das Verfahren nach irgendeinem der vorigen Ansprüche, wobei der Verbundstoff die folgenden Durchlässigkeitseigenschaften aufweist, festgestellt nach der Industrienorm NEN-EN 410,

(a) wenn das Substrat nur eine einzige Schichtfolge trägt, die in der Lage ist, einen dichroitischen Filter darzustellen:

• eine Durchlässigkeit von sichtbarem Licht (visible light transmittance - "VLT"), gewichtet wie für die Normlichtart D65, von mindestens 40 %, und/oder
• eine Durchlässigkeit im Wellenlängenbereich von 900 bis 1.000 nm ("T_IR"), gewichtet für die globale Sonnenstrahlung und die Gewichtungsfaktoren normalisiert über den spezifizierten Wellenlängenbereich, die niedriger ist als die VLT, wobei die T_IR bevorzugt höchstens 80 % beträgt,

und
(b) wenn das Substrat mindestens zwei Sequenzen trägt, die jeweils in der Lage sind, einen dichroitischen Filter darzustellen:

• eine Durchlässigkeit von sichtbarem Licht (visible light transmittance - "VLT"), gewichtet wie für die Normlichtart D65, von mindestens 50 %, und/oder
• eine Durchlässigkeit im Wellenlängenbereich von 900 bis 1.000 nm ("T_IR"), gewichtet für die globale Sonnenstrahlung und die Gewichtungsfaktoren normalisiert über den spezifizierten Wellenlängenbereich, die niedriger ist als die VLT, wobei die T_IR bevorzugt höchstens 70 % beträgt.

**Revendications**

**1.** Procédé de production d'un composite transmettant la lumière visible et réfléchissant les infrarouges, comprenant, collé sur un côté d'un support transparent, au moins un filtre dichroïque (DF) lequel filtre comprend au moins une couche métallique prise en sandwich entre deux couches d'oxyde métallique diélectrique, composé inorganique diélectrique ou sel inorganique diélectrique, dans lequel les couches du filtre dichroïque sont déposées séquentiellement sur le support transparent à l'aide d'un dépôt par pulvérisation dans au moins une chambre de pulvérisation, dans lequel le processus comprend, dans la chambre de pulvérisation où au moins une des couches diélectriques est pulvérisée, l'introduction d'au moins un gaz inerte et d'eau,
**caractérisé en ce que** l'écoulement molaire de l'eau introduite dans la chambre de pulvérisation est compris entre 1 % et 30 % par rapport à l'écoulement molaire total du gaz inerte introduit dans la même chambre de pulvérisation.

**2.** Procédé selon la revendication 1, dans lequel, dans la chambre de pulvérisation dans laquelle ladite au moins une des couches diélectriques est pulvérisée, la pression totale est contrôlée pour être au plus de 0,005 mbar, de préférence l'atmosphère dans la chambre de pulvérisation comprenant de l'argon comme ledit au moins un gaz inerte.

**3.** Procédé selon la revendication 1 ou 2, dans lequel, dans la chambre de pulvérisation dans lequel ladite au moins une des couches diélectriques est pulvérisée, la pression partielle de l'eau est maintenue dans la plage comprise entre au moins 0,00001 mbar et 0,0015 mbar.

4. Procédé selon l'une quelconque des revendications précédentes, dans lequel l'eau est introduite dans la chambre de pulvérisation sous forme de vapeur d'eau.

5. Procédé selon l'une quelconque des revendications précédentes, qui est mis en œuvre en mode continu, dans lequel un substrat flexible est acheminé à travers le processus en commençant par une chambre de déroulement d'alimentation et en terminant par une chambre d'enroulement de produit, et est acheminé entre ces chambres à travers une série de chambres de pulvérisation dans lesquelles les couches du filtre dichroïque sont ensuite déposées sur le substrat.

6. Procédé selon l'une quelconque des revendications précédentes, dans lequel la couche métallique contient au moins un métal choisi dans le groupe constitué de l'argent (Ag), le titane (Ti), le cuivre (Cu), l'or (Au), le platine (Pt), le palladium (Pd), l'aluminium (Al), le nickel (Ni), le chrome (Cr), le molybdène (Mo), le vanadium (V) ou l'acier inoxydable.

7. Procédé selon l'une quelconque des revendications précédentes, dans lequel le filtre dichroïque comprend en outre au moins une couche intermédiaire située entre la couche diélectrique et la couche métallique, dans lequel la couche intermédiaire comprend au moins un des métaux ou alliages du groupe constitué de l'or, l'argent, le palladium, le platine, le palladium, le ruthénium ou un autre métal précieux ou du groupe de platine, le nickel, le nickel allié au chrome, l'indium, le gallium, l'antimoine, l'arsenic, l'aluminium, l'antimoine et/ou l'arsenic avec l'indium et/ou le gallium, l'antimoniure d'indium, l'antimoniure de gallium, l'antimoniure d'indium-gallium, l'arséniure d'indium, l'arséniure de gallium, l'arséniure d'indium-gallium et l'arséniure d'aluminium-indium.

8. Procédé selon l'une quelconque des revendications précédentes, dans lequel la couche diélectrique comprend au moins un matériau non métallique qui est transparent à la fois au rayonnement visible et infrarouge.

9. Procédé selon la revendication précédente, dans lequel le support transparent est une couche de verre feuilleté, le procédé comprenant en outre l'assemblage du verre feuilleté.

10. Procédé selon la revendication précédente, dans lequel le verre feuilleté est utilisé dans une sculpture en verre, un panneau photovoltaïque, un panneau de protection contre les UV, ou dans la construction d'un bâtiment, d'une serre, d'un abri pour animaux ou d'une étable, ou d'un véhicule, de préférence comme une fenêtre dans une application architecturale, d'un véhicule, de préférence comme un verre de sécurité, un pare-brise, une autre fenêtre, un verre pare-balles ou un verre résistant à la pénétration, et ce dans un wagon, un vélo, un véhicule à moteur tel qu'une moto, une voiture, un camion, un bus, un véhicule ferroviaire tel qu'un train ou un tramway, un véhicule nautique tel qu'un navire, un bateau ou un véhicule sous-marin, un véhicule amphibie tel qu'un véhicule à propulsion à hélice ou un aéroglisseur, un aéronef tel qu'un avion, un hélicoptère ou un aérostat, ou dans un engin spatial, dans un escalier, sur un toit, dans un plancher, un auvent ou une poutre.

11. Procédé selon l'une quelconque des revendications 1 à 8, dans lequel le support transparent a un module de cisaillement à température ambiante typique d'un matériau flexible, ce qui signifie que le module de cisaillement est compris dans une plage d'au plus 0,5 GPa et d'au moins 0,1 MPa.

12. Procédé selon la revendication précédente, comprenant en outre l'étape consistant à fournir une couche adhésive sur au moins un côté du support transparent.

13. Procédé selon la revendication 8, comprenant en outre l'étape consistant à appliquer directement sur le filtre dichroïque un film protecteur constitué d'un autre film souple, d'un revêtement acrylate humide ou d'un revêtement humide appliqué par un procédé comprenant l'application d'une technique sol-gel.

14. Procédé selon l'une quelconque des revendications 11 à 13 comprenant en outre l'étape consistant à incorporer le composite en tant qu'élément de construction dans une structure, dans lequel le composite est utilisé sous au moins l'une des formes suivantes :

• Avec deux couches adhésives, l'une sur le côté du filtre dichroïque et l'autre sur le côté opposé, prises en sandwich entre deux plaques transparentes, formant ainsi un ensemble,
• Avec une couche adhésive collée sur un côté d'une plaque transparente telle qu'une plaque de verre, formant ainsi un ensemble, au moyen de la couche adhésive qui est prévue directement sur le filtre dichroïque ou, en variante, sur le côté opposé du composite,

• Avec un film protecteur tendu entre les surfaces 2 et 3 du verre isolant, les surfaces du verre isolant étant numérotées selon la pratique standard avec les unités de verre isolant (« IGU ») pour numéroter les surfaces en commençant par attribuer le numéro 1 (un) à la surface extérieure de l'unité de verre, puis en augmentant séquentiellement le numéro pour les surfaces suivantes rencontrées lorsque l'on compte vers la surface intérieure de l'unité de verre, formant ainsi un ensemble,

• Avec un film protecteur pris en sandwich entre deux couches de plastique intermédiaire qui sont prises en sandwich entre les deux plaques transparentes rigides, formant ensemble un ensemble.

**15.** Procédé selon l'une quelconque des revendications précédentes, dans lequel le composite présente les caractéristiques de transmission suivantes, établies conformément à la norme industrielle NEN-EN 410,

(a) si le substrat ne porte qu'une seule séquence de couches capable de représenter un filtre dichroïque :

• une transmittance de la lumière visible (« VLT »), pondérée comme pour la référence d'illuminant D65, d'au moins 40 %, et/ou
• une transmittance dans la gamme de longueurs d'onde de 900 à 1000 nm (« T_IR »), pondérée pour le rayonnement solaire global et les facteurs de pondération normalisés sur la gamme de longueurs d'onde spécifiée, qui est inférieure à la VLT, de préférence la T_IR étant au maximum de 80 %,

et

(b) si le substrat porte au moins deux séquences capables chacune de représenter un filtre dichroïque :

• une transmittance de la lumière visible (« VLT »), pondérée comme pour la référence d'illuminant D65, d'au moins 50 %, et/ou
• une transmittance dans la gamme de longueurs d'onde de 900 à 1000 nm (« T_IR »), pondérée pour le rayonnement solaire global et les facteurs de pondération normalisés sur la gamme de longueurs d'onde spécifiée, qui est inférieure à la VLT, de préférence la T_IR étant au maximum de 70 %.

## Figure 1

## Figure 2

## Figure 3

## Figure 4

## Figure 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9034459 B2
- US 4204942 A
- US 20150021168 A1
- US 4799745 A
- US 7709095 B
- US 5510173 A
- EP 1588950 B1
- WO 2012080951 A1
- WO 2017097779 A1
- WO 2023170215 A1

**Non-patent literature cited in the description**

- **MUSIKANT**. Optical Materials. Marcel Dekker, 1985, 17-96